# EUROPEAN PATENT APPLICATION

(11) **EP 3 125 323 A1**
(43) Date of publication of application: **01.02.2017**
(21) Application number: 15768744.3
(22) Date of filing: 02.02.2015
(51) Int. Cl.: H01L 51/46

(54) **SOLAR CELL**

(30) Priority: 27.03.2014 JP 2014065938
(71) Applicant: Fujifilm Corporation, Minato-ku Tokyo 106-8620 (JP)
(72) Inventor: MAEHARA Yoshiki, Ashigarakami-gun Kanagawa 258-8577 (JP)
(74) Representative: Hoffmann Eitle
(86) International application number: PCT/JP2015/052832
(87) International publication number: WO 2015/146284

(57) **Abstract**

A solar cell includes, on a support: a transparent negative electrode; auxiliary metal wiring that is in contact with the negative electrode; a positive electrode that faces the negative electrode; and a photoelectric conversion layer between the negative electrode and the positive electrode, and between the negative electrode and the photoelectric conversion layer, in which the electron transport layer includes an electron transport material and an insulating material, and the insulating material is a crosslinking macromolecule obtained by crosslinking a crosslinkable macromolecule with a compound having a plurality of crosslinkable groups.

## Description

### BACKGROUND OF THE INVENTION

### 1. Field of the Invention

The invention relates to a solar cell.

### 2. Description of the Related Art

The solar cell generally comprises a pair of electrodes provided on a support, a charge blocking layer (a hole transport layer or an electron transport layer) between the pair of electrodes, and a photoelectric conversion layer.

Recently, particularly, demands on a solar cell that is lightweight, that is flexible so as to be applied to various places, and that has a reduced cost increase.

For example, in JP2006-521700A, a photoelectric cell (organic thin film solar cell) having a metal electrode (mesh electrode) with a mesh pattern as auxiliary wiring for a negative electrode is disclosed, and the fact that this mesh electrode has sufficient flexibility is also disclosed (paragraph "0019").

Research on methods and materials for forming electron transport layers provided between negative electrodes and photoelectric conversion layers of solar cells is conducted.

For example, in US2011/0049504A, a method of forming an electron transport layer by applying a dispersing liquid in which titanium dioxide particles are dispersed is suggested.

In addition, as materials for forming charge blocking layers (hole transport layers and electron transport layers), uses of insulating materials such as inorganic oxide, inorganic fluoride, or inorganic nitride (JP2006-521700A and JP2009-182095A), or binder resins (JP2008-74813A, JP2003-332075A, and JP2004-119555A) and conductive materials are also suggested.

### SUMMARY OF THE INVENTION

In a flexible solar cell, it is required that photoelectric conversion efficiency thereof is not changed by the forms of uses thereof, particularly, before or after folding.

However, in a solar cell provided with mesh electrodes or auxiliary metal wiring as in JP2006-521700A, photoelectric conversion efficiency decreases by folding. Prevention of decrease of durability against the folding is not sufficient, even if an electron transport layer is formed by a method disclosed in US2011/0049504A, or insulating materials and conductive materials are simply used together, as materials of electron transport layers as disclosed in JP2009-182095A, JP2008-74813A, JP2003-332075A, and JP2004-119555A, and there is room for improvement.

An object of the invention is to provide a solar cell having excellent durability against folding.

The present inventors have found that, if a flexible solar cell is folded, negative electrodes easily concentrate in vicinity of a corner portion of auxiliary metal wiring, folding stress easily concentrates in an electron transport layer, cracks are generated, and peeling between layers occurs.

The present inventors have further conducted research to find that, if an electron transport layer is formed by using an electron transport material and a specific crosslinking macromolecule together, flexibility increases, and thus, even if the electron transport layer is in contact with an auxiliary metal wiring or a negative electrode, the generation of cracks and peeling between layers become difficult. The invention is completed based on this knowledge.

That is, the problems described above are solved by the means described below.
<1> A solar cell comprising, on a support: a transparent negative electrode; auxiliary metal wiring that is in contact with the negative electrode; a positive electrode that faces the negative electrode; a photoelectric conversion layer between the negative electrode and the positive electrode; and an electron transport layer between the negative electrode and the photoelectric conversion layer,
   in which the electron transport layer includes an electron transport material and an insulating material, and the insulating material is a crosslinking macromolecule obtained by crosslinking a crosslinkable macromolecule with a compound having a plurality of crosslinkable groups.
<2> The solar cell according to <1>, in which the crosslinkable group also functions as a reactive group that chemically bonds to a material for forming the negative electrode or the auxiliary metal wiring with which the electron transport layer is in contact.
<3> The solar cell according to <1> or <2>, in which the negative electrode contains a conductive macromolecule.
<4> The solar cell according to any one of <1> to <3>, in which the negative electrode contains a polymer of a compound having the plurality of crosslinkable groups.
<5> The solar cell according to any one of <1> to <4>, in which the electron transport material is metal oxide.
<6> The solar cell according to any one of <1> to <5>, further includes a porous layer between the electron transport layer and the photoelectric conversion layer.
<7> The solar cell according to any one of <1> to <6>, in which the photoelectric conversion layer contains an electron-donating organic compound.
<8> The solar cell according to any one of <1> to <6>, in which the photoelectric conversion layer contains a compound having a perovskite structure.
<9> The solar cell according to any one of <1> to <8>, in which the support is flexible.
<10> The solar cell according to any one of <1> to <9>, further comprising: a second support bonded to a side opposite to the support.

The description of compounds in this specification is used in the meaning of including salts thereof and ions thereof, in addition to the compounds themselves. The description of compounds may include compounds of which a portion of the structure thereof is changed. With respect to the compounds of which substitution or non-substitution is not described, the compounds may have an arbitrary substituent in the scope of exhibiting the effect of the purposes.

Numerical ranges exhibited by using the expression "to" in this specification mean ranges including numerical values described before and after the expression "to" as lower limits and upper limits.

According to the invention, it is possible to provide a solar cell having excellent durability with respect to folding.

### BRIEF DESCRIPTION OF THE DRAWINGS

Fig. 1 is a diagram schematically illustrating a structure of a solar cell according to the invention.
Fig. 2 is a diagram schematically illustrating another structure of the solar cell according to the invention.
Fig. 3 is a diagram schematically illustrating still another structure of the solar cell according to the invention.

### DESCRIPTION OF THE PREFERRED EMBODIMENTS

### <Solar cell>

The solar cell according to the invention has a transparent negative electrode, auxiliary metal wiring that is in contact with the negative electrode, a positive electrode that faces the negative electrode, a photoelectric conversion layer provided between the negative electrode and the positive electrode, and an electron transport layer provided between the negative electrode and the photoelectric conversion layer, on a support. If the solar cell according to the invention at least has such a structure, other structures are not particularly limited.

According to the invention, a photoelectric conversion unit (photoelectric conversion element) that constitutes a solar cell is also included in the solar cell.

A preferred structure of the solar cell according to the invention is described with reference to the drawings.

Solar cells illustrated in the drawings are schematically illustrated in order to cause the invention easily understood. With respect to the sizes and relative size relationships of the respective members, sizes may be changed for easier understanding in some cases, so the drawings do not illustrate actual relationships. Otherwise the contents are regulated in the invention, the appearance and the shapes are not limited those illustrated in the drawings.

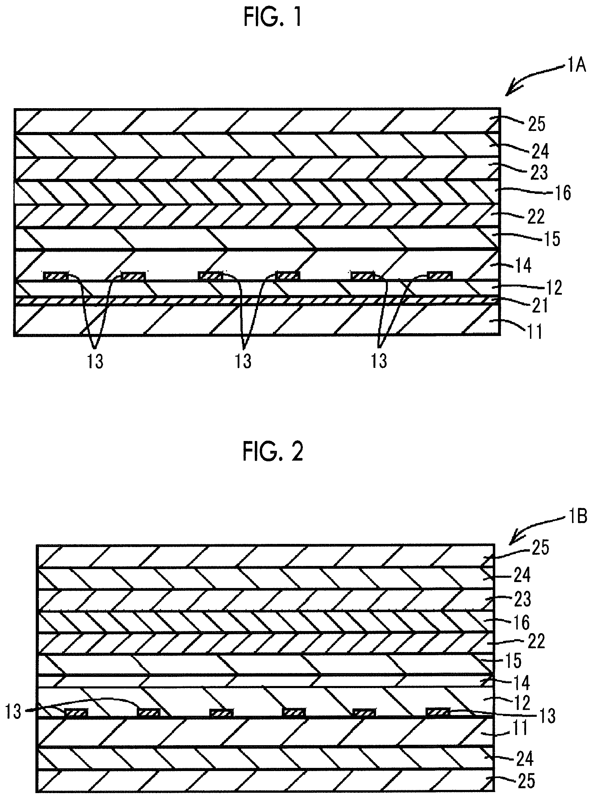

Figs. 1 to 3 are longitudinal sectional views schematically illustrating preferable structures of the solar cell, respectively. In Figs. 1 to 3, reference numeral 11 represents a support, reference numeral 12 represents a negative electrode, reference numeral 13 represents auxiliary metal wiring, reference numeral 14 represents an electron transport layer, reference numeral 15 represents a photoelectric conversion layer, reference numeral 16 represents a positive electrode, and reference numeral 17 represents a porous layer. Reference numeral 21 represents a gas barrier layer, reference numeral 22 represents a hole transport layer, reference numeral 23 represents a protective layer, reference numeral 24 represents an adhesive layer, and reference numeral 25 represents a sealing film (second support).

In a solar cell 1A illustrated in Fig. 1, the gas barrier layer 21, the negative electrode 12, the auxiliary metal wiring 13, the electron transport layer 14 covering the auxiliary metal wiring 13 and the negative electrode 12, the photoelectric conversion layer 15, the hole transport layer 22, the positive electrode 16, the protective layer 23, the adhesive layer 24, and the sealing film 25 are sequentially provided on the support 11.

A solar cell 1B illustrated in Fig. 2 is the same as the solar cell 1A, except that the auxiliary metal wiring 13 is provided inside the negative electrode 12 on the support 11, and the sealing film 25 is provided on the other surface of the support 11 via the adhesive layer 24.

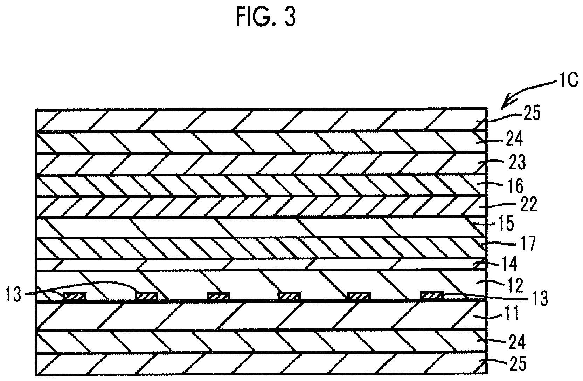

A solar cell 1C illustrated in Fig. 3 is the same as the solar cell 1B, except that the porous layer 17 is provided between the electron transport layer 14 and the photoelectric conversion layer 15.

The solar cells 1A to 1C can be, respectively, used for batteries that cause the negative electrode 12 and the positive electrode 16 to work operation means (electric motors or various (opto) electronics devices) by using external circuits.

The solar cell according to the invention has flexibility. The flexibility is appropriately selected according to the purpose, the material of the support, the manufacturing method, or the like. For example, as a standard in which photoelectric conversion characteristics are not lowered due to handling before and after the manufacturing, and deformation due to heating, cooling, or the like, it is preferable that a curve having a curvature radius of 2 cm or less can be formed, it is more preferable that a curve having a curvature radius of 1 cm or less can be formed.

The solar cell according to the invention has flexibility as above and may be used by being folded. In this use embodiment or an embodiment of having the auxiliary metal wiring 13, the electron transport layer 14 has flexibility, cracks are hardly generated in the electron transport layer 14 due to folding, and interlayer peeling with the negative electrode 12 is hardly generated.

### <Support>

The support 11 is not particularly limited, as long as the support can preserve a solar cell consisting of respective layers formed thereon. For example, glass, a plastic film, or the like can be appropriately selected according to the purposes.

According to the invention, in view of forming a flexible solar cell, the support 11 is preferably a support having flexibility such as a plastic film. The flexibility that the plastic film (the support 11) has is preferably the same as the flexibility of the solar cell according to the invention.

Hereinafter, as a representative example of the support, a plastic film is described.

Specifically, examples of the material of the plastic film include a thermoplastic resin such as a polyester resin, a methacrylic resin, a resin consisting of a methacrylic acid-maleic acid copolymer, a polystyrene resin, a fluororesin, a polyimide resin, a fluorinated polyimide resin, a polyamide resin, a polyamideimide resin, a polyetherimide resin, a cellulose acrylate resin, a polyurethane resin, a polyetheretherketone resin, a polycarbonate resin, an alicyclic polyolefin resin, a polyacrylate resin, a polyethersulfone resin, a polysulfone resin, a resin consisting of a cycloolefin copolymer, a fluorene ring-modified polycarbonate resin, an alicyclic ring-modified polycarbonate resin, a fluorene ring-modified polyester resin, and an acryloyl compound.

The plastic film preferably has heat resistance. Specifically, at least some physical properties in which a glass transition temperature (Tg) is 100°C or higher and a linear expansion coefficient is 40 ppm/K or less are preferably satisfied.

The Tg and the linear expansion coefficient of the plastic film are measured by a method for measuring a transition temperature of plastic disclosed in JIS-K7121 and a linear expansion test method by a thermochemical analysis of plastic disclosed in JIS-K7197. According to the invention, values measured by this method are used.

Tg of a plastic film or a linear expansion coefficient can be adjusted by an additive or the like. Examples of such a thermoplastic resin having excellent heat resistance include polyethylene naphthalate (PEN: 120°C (Tg, the same applies to the following)), polycarbonate (PC:140°C), alicyclic polyolefin (for example, ZEONOR 1600 (Product Name) manufactured by ZEON Corporation: 160°C), polyacrylate (PAr: 210°C), polyethersulfone (PES: 220°C), polysulfone (PSF: 190°C), a cycloolefin copolymer (COC: compounds disclosed in JP2001-150584A: 162°C), fluorene ring-modified polycarbonate (BCF-PC: compounds disclosed in JP2000-227603A: 225°C), alicyclic ring-modified polycarbonate (IP-PC: compounds disclosed in JP2000-227603A: 205°C), an acryloyl compound (compounds disclosed in JP2002-80616A: 300°C or higher), and polyimide. Among these, polyethylene naphthalate is preferable.

According to the invention, the support 11 is required to be transparent with respect to light. Specifically, the light transmittance with respect to the light having a wavelength range of 400 to 800 nm is generally preferably 80% or greater, more preferably 85% or greater, and even more preferably 90% or greater. The light transmittance can be calculated by the method disclosed in JIS-K7105, that is, by measuring the total light transmittance and a scattered light amount using an integrating sphere-type light transmittance measuring device and subtracting diffuse transmittance from the total light transmittance.

The thickness of the support 11 is not particularly limited, but typically 1 to 800 µm and preferably 10 to 300 µm.

### <Function layer>

Well-known function layers may be provided on the back surface (the surface on the side on which the negative electrode or the like are not provided) of the support 11. Examples of the function layer include a gas barrier layer, a matting agent layer, an antireflection layer, a hardcoat layer, an antifogging layer, and an antifouling layer, and the function layers are specifically disclosed in paragraphs "0036" to "0038" of JP2006-289627A.

### <Easily adhesive layer/undercoat layer>

The support 11, particularly the surface of the plastic film (the surface on the side on which the negative electrode or the like is provided) may be provided with an easily adhesive layer or an undercoat layer, in view of adhesiveness improvement. The easily adhesive layer or the undercoat layer may be single layers or multiple layers.

In the forming of the easily adhesive layer or the undercoat layer, various hydrophilic coating polymers are used. As the hydrophilic coating polymer, gelatin, a gelatin derivative, casein, agar, sodium alginate, starch, a water soluble polymer such as polyvinyl alcohol, cellulose ester such as carboxymethyl cellulose and hydroxyethyl cellulose, a vinyl chloride-containing copolymer, a vinylidene chloride-containing copolymer, an acrylic acid ester-containing copolymer, a vinyl acetate-containing copolymer, a latex polymer consisting of a butandiene-containing copolymer or the like, a polymer consisting of an polyacrylic copolymer, a polymer consisting of a maleic anhydride copolymer, and the like are exemplified.

The coating film thickness of the easily adhesive layer or the undercoat layer after drying is preferably in the range of 50 nm to 2 µm. In the case where a support is used as a temporary support, easy peeling properties may be applied to the surface of the support.

### <Negative electrode>

The negative electrode 12 may be provided on the support 11. The negative electrode 12 is preferably a transparent negative electrode that transmits light from visible light to near infrared light (380 to 800 nm). Here, the expression "transparent" means that an average light transmittance of light from visible light to near infrared light is 75% or greater. A layer constitution of the negative electrode is not particularly limited, but may be a single layer structure or a multiple layer structure.

The material for forming the negative electrode is not particularly limited, but examples thereof include metal, metal oxide, conductive macromolecule, or a mixture thereof. Among these, in view of flexibility, a conductive macromolecule is preferable.

Examples of the metal include metal such as magnesium, aluminum, calcium, titanium, chromium, manganese, iron, copper, zinc, strontium, silver, indium, tin, barium, and bismuth, and an alloy thereof.

Examples of the metal oxide include transparent conductive oxide (TCO) such as tin oxide, fluorine-doped tin oxide (FTO), zinc oxide, antimony doped zinc oxide (AZO), indium oxide, indium tin oxide (ITO), indium zinc oxide (IZO), and indium tungsten oxide (IWO).

The conductive macromolecule is not particularly limited, as long as the conductive macromolecule is a macromolecular compound having conductivity. Charge carriers that perform transporting may be any one of holes and electrons. Specific examples of the conductive macromolecule include polythiopene, polypyrrole, polyaniline, polyphenylenevinylene, polyphenylene, polyacetylene, polyquinoxaline, polyoxadiazole, and polybenzothiadiazole, or a macromolecular compound having plural conductive skeletons.

Among these, polythiopene is preferable, and polyethylenedioxythiopene and polythienothiopene are particularly preferably. In general, this polythiopene may be partially oxidized, in order to obtain conductivity. The electrical conductivity of the conductive macromolecule can be adjusted by the degree (doping amount) of the partial oxidation. As the doping amount becomes greater, the electrical conductivity becomes higher. Since polythiopene becomes cationic due to the partial oxidation, a counter anion is required in order to neutralize the charges. Examples of this polythiopene include polyethylenedioxythiopene (PEDOT-PSS) having polystyrene sulfonate as a counter anion.

With respect to the conductive macromolecule, the independent volume resistivity is preferably 1 × 10⁻¹ Ω·cm or less and more preferably 1 × 10⁻² Ω·cm or less. If such a conductive macromolecule is included, the volume resistivity of the negative electrode is preferably 5 × 10⁻¹ Ω·cm or less and more preferably 5 × 10⁻² Ω·cm or less.

The conductive macromolecule constituting the negative electrode is required to be transparent in an action spectrum range of the solar cell to be applied and generally is required to have excellent light transmittance of light from visible light to near infrared light. Specifically, when the conductive macromolecule is formed on the layer having the thickness of 0.2 µm, average light transmittance in an area having a wavelength of 380 to 800 nm is preferably in the range above.

If the conductive macromolecule is in the range that does not deteriorate desired conductivity, the conductive macromolecule may be used together with other polymers. The other polymers are used for the purpose of increasing film hardness. Examples of the other polymers include a thermoplastic resin such as a polyester resin, a methacrylic resin, a resin consisting of a methacrylic acid-maleic acid copolymer, a polystyrene resin, a transparent fluororesin, a polyimide resin, a fluorinated polyimide resin, a polyamide resin, a polyamideimide resin, a polyetherimide resin, a cellulose acrylate resin, a polyurethane resin, a polyetheretherketone resin, a polycarbonate resin, an alicyclic polyolefin resin, a polyacrylate resin, a polyethersulfone resin, a polysulfone resin, a resin consisting of a cycloolefin copolymer, a fluorene ring-modified polycarbonate resin, an alicyclic ring-modified polycarbonate resin, a fluorene ring-modified polyester resin, and an acryloyl compound, and hydrophilic polymers such as gelatin, polyvinyl alcohol, polyacrylic acid, polyacrylamide, polyvinylpyrrolidone, polyvinylpyridine, and polyvinylimidazole.

The negative electrode preferably contains a polymer (polymer obtained by polymerizing crosslinkable groups of a compound having plural crosslinkable groups with each other) of a compound having plural crosslinkable groups. Particularly, in a case where a conductive macromolecule is used as a material for forming the negative electrode, the negative electrode preferably contains this polymer. This polymer may be a polymer (crosslinking substance) obtained by reacting with a conductive macromolecule and may be a homopolymer of a compound having plural crosslinkable groups. The polymer is preferably a homopolymer.

This compound for forming the polymer may be a compound having plural crosslinkable groups as described below and preferably also function as a polymerizable group with which a crosslinkable group can be polymerized. Specifically, examples thereof include various types of metal alkoide, a silane coupling agent, a polyfunctional epoxy monomer, a polyfunctional isocyanate monomer, a polyfunctional (meth)acryl monomer, and a methylol melamine derivative.

Examples of this polymer of the compound having plural crosslinkable groups include metal oxide gel, polysiloxane, an epoxy resin, an urethane resin, a (meth)acryl resin, and a melamine resin.

In the negative electrode, a content ratio of the polymer of the compound having plural crosslinkable groups is not particularly limited.

If the negative electrode contains the polymer of the compound having the plural crosslinkable groups as an insulating material, the flexibility of the negative electrode increases, the generation of cracks due to folding can be prevented. Particularly, in the solar cells 1B and 1C having structures illustrated in Figs. 2 and 3, the negative electrode 12 contains a conductive macromolecule and the polymer of the compound having the plural crosslinkable groups, an improvement effect of the flexibility increases. The adhesiveness with the electron transport layer can be improved. Here, the reason that the improvement effect of the flexibility is exhibited is not clear, but it is considered that the reason is as the electron transport layer described below.

The thickness of the negative electrode is not particularly limited, as long as transparency can be secured, but the thickness is preferably 0.05 to 1 µm and even more preferably 0.1 to 0.3 µm.

### <Auxiliary metal wiring>

According to the invention, the auxiliary metal wiring 13 that is in contact with the negative electrode 12 is arranged on the support 11 or the negative electrode 12. The auxiliary metal wiring 13 having high conductivity is provided so as to be in contact with the negative electrode 12, conductivity of the solar cell is improved. The auxiliary metal wiring 13 is not required to be provided on the support 11 side (lower side in Figs. 1 to 3) of the negative electrode 12 and may be formed at least to be in contact with the negative electrode 12. For example, as illustrated in Fig. 1, after the negative electrode 12 is firstly formed on the support 11, the auxiliary metal wiring 13 may be formed on the negative electrode 12, or as illustrated in Figs. 2 and 3, the negative electrode 12 may be provided so as to cover the auxiliary metal wiring 13 provided on the support 11.

The auxiliary metal wiring is formed so as to include various types of metal material. Examples of the metal material include gold, platinum, iron, copper, silver, aluminum, chromium, cobalt, and stainless steel. As the metal material, a metal material having volume resistivity of 1 × 10⁻⁵ Ω·cm or less is preferable, and specific examples thereof include low resistance metal such as copper, silver, aluminum, and gold. Among these, silver or copper that have low manufacturing costs and material costs, and that are hardly oxidized are particularly preferably used.

The pattern shape of the auxiliary metal wiring 13 is not particularly limited, but in view of light transmittance and conductivity, the mesh-shaped pattern (mesh pattern electrode) is preferable. The mesh pattern is not particularly limited, examples thereof include a lattice form such as a square, a rectangle, and a diamond, and a combination of a stripe shape, honeycomb, or a curve.

In order to suppress the stress concentrate at the time of folding, a cross-sectional shape of the auxiliary metal wiring 13 is preferably a shape not having a corner portion. However, in this invention, the electron transport layer described below has sufficient flexibility, and thus the shape is not particularly limited. For example, as illustrated in Figs. 1 to 3, the electron transport layer can be formed to have a rectangular cross-section having a corner portion.

The mesh design of the auxiliary metal wiring 13 is adjusted such that opening ratio (light transmittance) and the surface electrical resistance (electrical conductivity) have desired values. In a case where the auxiliary metal wiring 13 is formed to be auxiliary metal wiring having such a mesh pattern, the opening ratio of the mesh is generally 70% or greater, preferably 80% or greater, and more preferably 85% or greater. The light transmittance and the electrical conductivity has a trade-off relationship, and thus the opening ratio is preferable as the opening ratio is greater, but practically 95% or less.

The surface electrical resistance of the auxiliary metal wiring 13 in a state in which the negative electrode 12 is not provided is preferably 10 Ω/□ or less, more preferably 3 Ω/□ or less, and even more preferably 1 Ω/□ or less.

The thickness of the auxiliary metal wiring is not particularly limited, but generally about 0.02 to 20 µm.

With respect to the line width of the auxiliary metal wiring, in view of the light transmittance and the conductivity, the line width in a plan view is in the range of 1 to 500 µm, and preferably 10 to 300 µm.

As the pitch of the auxiliary metal wiring is smaller (mesh is narrow), the pitch is more advantageous in view of characteristics of the solar cell. However, if the pitch is small, the transmittance of the light decreases. Therefore, the pitch is appropriately determined after the pitch and the transmittance are compared and considered. For example, the pitch changes according to the line width of the auxiliary metal wiring, but the pitch in a plan view is preferably 0.05 to 5 mm and more preferably 0.1 to 3 mm.

For large scale current collection, the auxiliary metal wiring may have a bus line (heavy line). The line width of the bus line or the pitch is appropriately selected according to the material used.

The method for forming the auxiliary metal wiring is not particularly limited, but well-known forming methods are appropriately used. Examples thereof include a method for bonding mesh pattern metal manufactured in advance to the surface of the support 11, a method for coating a mesh pattern with a conductive material, a method for forming a conductive film of a mesh pattern after a conductive film is formed on the entire surface by using vapor deposition or physical vapor deposition (PVD method) such as sputtering and etched, a method for coating a mesh pattern with a conductive material by various printing methods such as screen printing and inkjet printing, a method for forming auxiliary wiring for a positive electrode of a mesh pattern directly on the surface of the support 11 by using a shadow mask by vapor deposition or sputtering, and a method for using a silver halide photosensitive material disclosed in JP2006-352073A and JP2009-231194A (hereinafter, also referred to as a "silver salt method").

In a case where the auxiliary metal wiring is formed as a mesh electrode, the pitch thereof is small, and thus the auxiliary metal wiring is preferably formed in a silver salt method. In a case where the auxiliary metal wiring is formed by the silver salt method, the auxiliary metal wiring having the desired pattern can be formed on the support in a step of coating the support with a coating liquid for forming the auxiliary metal wiring and performing pattern exposure on the coated film for forming the auxiliary metal wiring, a step of developing the coated film subjected to the pattern exposure, and a step of fixing the developed coated film.

The auxiliary metal wiring manufactured by the silver salt method is a layer of silver and a hydrophilic polymer. As examples of the hydrophilic polymer, gelatin, gelatin derivative, casein, agar, sodium alginate, starch, water soluble polymer such as polyvinyl alcohol, and cellulose ester such as carboxymethyl cellulose and hydroxyethyl cellulose are exemplified. In addition to silver or a hydrophilic polymer, substances derived from coating, developing, and fixing steps are included in the layer.

A method of obtaining auxiliary metal wiring is also preferably used by performing copper plating after the auxiliary metal wiring is formed by the silver salt method, further increasing conductivity, and suppressing ion migration.

In a case where the auxiliary metal wiring is provided on the support, a smoothed layer having the surface which becomes the same as the surface of the auxiliary metal wiring can be provided. The smoothed layer is not particularly limited, as long as the smoothed layer is made of a transparent material. Particularly, transparent inorganic materials such as silicon nitride, silicon oxide, silicon nitride oxide or resin materials such as methacrylate can be used.

### <Electron transport layer>

The electron transport layer 14 is formed on the negative electrode 12 and the auxiliary metal wiring 13. The electron transport layer 14 may be called an electron collecting layer, a hole blocking layer, or the like.

This electron transport layer 14 at least contains an electron transport material and a crosslinking macromolecule as an insulating material.

The electron transport material and the crosslinking macromolecule may exist (be contained) in the electron transport layer 14, may independently exist respectively, or may be exist by forming, for example, a composite, by chemical or physical interaction or the like. The electron transport layer 14 may have an un-crosslinked macromolecular compound or a polyfunctional compound.

The reason that durability with respect to folding is excellent if the electron transport layer contains a crosslinking macromolecule is not clear, but it is assumed as follows. That is, in the electron transport layer, a crosslinking macromolecule is interposed between electron transport materials, such that folding stress can dispersed and buffered. Even if a defect or the like is generated in a portion of the electron transport material due to the deformation of folding or the like, the decrease of the electron transport properties can be suppressed by preventing the propagation of defects to the entire electron transport layer such that flexibility of the electron transport layer increases.

If the electron transport layer containing the electron transport material and the crosslinking macromolecule is formed, the electron transport material, particularly, the generation of defects at the time of coating the electron transport layer consisting of metal oxide fine particles with the photoelectric conversion layer. That is, the solar cell having the plastic film as the support, having the electron transport layer formed by being coated with a coating liquid including metal oxide fine particles, and having flexibility is required by baking the electron transport layer at the low temperature such that the material of the plastic film is not decomposed. However, if the solar cell is baked at the low temperature, a dispersing agent for improving dispersibility in the coating liquid of the metal oxide fine particles remains in the electron transport layer. Therefore, when the photoelectric conversion layer is formed by coating, the metal oxide fine particles are re-dispersed in the coating liquid for forming the photoelectric conversion layer, such that defects of the electron transport layer are generated.

However, in this invention, the metal oxide fine particles are fixed by the crosslinking macromolecule, and thus re-dispersion of the metal oxide fine particles can be prevented.

In a case where the negative electrode includes the conductive macromolecule, both of the negative electrode and the electron transport layer preferably include the same polymers of the compounds having plural crosslinkable groups. According to this constitution, peeling of the negative electrode including the conductive macromolecule and the electron transport layer is suppressed, and the generation of the defect such as cracks in the electron transport layer itself can be prevented. In the manufacturing of the solar cell, after a coating liquid including the conductive macromolecule and a coating liquid including the electron transport material are applied by using the same crosslinking polyfunctional compound, if the polyfunctional compounds of both of the coating liquids are collectively subjected to the crosslinking reaction, the polymerization reaction, or the like, by heating or irradiation with electromagnetic waves (ultraviolet light, visible light, and infrared light), the mesh-shaped macromolecule expanding to the negative electrode and the electron transport layer or the polymer of the polyfunctional compound are formed, such that flexibility and durability of the solar cell can be improved.

### (Electron transport material)

Examples of the electron transport material include the electron accepting material included in the photoelectric conversion layer described below and electron transport materials disclosed in Chemical Reviews, Vol. 107, pages 953 to 1010 (2007) as "Electron-Transporting and Hole-Blocking Materials".

Fluoride, oxide, carbonate of alkali metal or alkali earth metal, and the like are used.

Among these, various types of metal oxide are preferably used as the material of the electron transport layer having high stability. Examples thereof include lithium oxide, magnesium oxide, aluminum oxide, silicon oxide, calcium oxide, titanium oxide, zinc oxide, strontium oxide, niobium oxide, ruthenium oxide, indium oxide, barium oxide, and tungsten oxide. Among these, aluminum oxide, titanium oxide, and zinc oxide which are relatively stable are more preferable.

### (Insulating material)

The insulating material is not particularly limited, as long as the insulating material is a crosslinking macromolecule having insulating properties obtained by performing crosslinking reaction between one or more types of compounds (also referred to as a "polyfunctional compound") having plural crosslinkable groups (functional groups that can be involved in crosslinking reaction) and one or more types of macromolecular compounds. If the electron transport layer contains such an insulating material together with an electron transport material, durability of the electron transport layer in the solar cell having flexibility can be improved.

The crosslinking macromolecule is preferably a crosslinking substance which has a crosslinking portion that is subjected to the crosslinking reaction with the macromolecular compound using the polyfunctional compound as a crosslinking agent, and in which a macromolecular compound is crosslinked in a mesh shape. Accordingly, the flexibility of the electron transport layer and durability of the solar cell become excellent.

### [Macromolecular compound]

The macromolecular compound for forming the crosslinking macromolecule is not particularly limited and appropriately selected according to the purposes. However, it is preferable to have a crosslinking group that performs crosslinking reaction with the crosslinkable group of the polyfunctional compound. Examples thereof include an organic resin, a silicon resin (silicone resin), and a macromolecular compound obtained by hydrolyzing and polycondensating the metal alkoxide compounds (sol gel method).

The organic resin and the silicon resin are not particularly limited, and can be appropriately selected according to the purpose. As the organic resin, a monomer (a monomer) or a polymer (an oligomer or a polymer) that form a thermoplastic resin or a thermosetting resin can be used singly or in combination.

Examples of the crosslinking group having the macromolecular compound include a silyl group having a hydrolysable group (for example, an alkoxysilyl group and an acyloxysilyl group), a group having a reactive unsaturated double bond (for example, a (meth)acryloyl group, an allyl group, a vinyloxy group), an open ring polymerizable reactive group (for example, an epoxy group, an oxetanyl group, and an oxazolyl group), a group having an active hydrogen atom (for example, a hydroxyl group, a carboxyl group, an amino group, a carbamoyl group, a mercapto group, a β-ketoester group, a hydrosilyl group, and a silanol group), an isocyanate group, a formyl group (an aldehyde group), a methylol group, an acid anhydride group, a group that can be substituted with a nucleophilic agent (an active halogen atom, a sulfonic acid ester, and the like).

Among these, an open ring polymerizable reactive group (particularly an epoxy group), a group having an active hydrogen atom (particularly, a hydroxyl group, a carboxyl group, an amino group, and a silanol group), an isocyanate group, a formyl group, a methylol group, and the like are preferable, and a hydroxyl group, a carboxyl group, an amino group, and a methylol group are particularly preferable.

As the monomer, a hydrophilic monomer component that can be chemically bonded to metal oxide that is preferably used in the negative electrode, the auxiliary metal wiring, or the electron transport material is preferable, and examples thereof include components such as a tetrahydrofurfuryl group, a phosphoric acid portion, a phosphoric acid ester portion, a portion of quaternary ammonium salt, an ethyleneoxy chain, a propyleneoxy chain, a sulfonic acid group and salts thereof, a monomer including a morpholinoethyl group and the like, alkoxyalkyl (meth)acrylate, hydroxyalkyl (meth)acrylate, glycerol (meth)acrylate, (meth)acrylamide, N-methylolacrylamide, secondary or tertiary alkylacrylamide, dialkylaminoalkyl (meth)acrylate, morpholine (meth)acrylate, N-vinylpyrolidone, N-vinylcaprolactam, vinylimidazole, vinyltriazole, methyl (meth)acrylate, ethyl (meth)acrylate, branched or linear propyl (meth)acrylate, branched or linear butyl (meth)acrylate, phenoxyhydroxypropyl (meth)acrylate, and 2-, 3-, or 4-vinylphenol.

Examples of the organic resin include various polymers described in the other polymers that can be used together with the conductive macromolecule that constitutes the negative electrode, polyvinylphenol, polyvinylbutyral, and polyethylene glycol.

Examples of the silicon resin include various types of polysiloxane, polyorganosiloxane, and polysilsesquioxane.

Among these, poly(4-vinylphenol), polyvinylbutyral, and polyvinyl alcohol is preferable, since these compounds can be chemically bonded to metal oxide that is preferably used in the negative electrode, the auxiliary metal wiring, and the electron transport material.

### [Polyfunctional compound]

According to the invention, the polyfunctional compound has plural crosslinkable groups, and can use a crosslinkable group that performs crosslinking reaction with the macromolecular compound without particular limitation. Preferably, the crosslinkable group performs reaction, polymerization, and interaction with a material that is contained in the negative electrode or the auxiliary metal wiring.

### 1. Polyfunctional compound that performs crosslinking reaction with macromolecular compound

The polyfunctional compound has plural crosslinkable groups and functions as a crosslinking agent that is crosslinked with the macromolecular compound.

The polyfunctional compound is not particularly limited, as long as the polyfunctional compound is a compound that has preferably 2 to 6 crosslinkable groups.

The crosslinkable group is not particularly limited, as long as the crosslinkable group is a group that performs crosslinking reaction with a crosslinking group of the macromolecular compound or a group that reacts with other crosslinkable groups. Examples of the crosslinkable group include a crosslinkable group that is the same as the crosslinking group included in the macromolecular compound. Among these, a silyl group having a hydrolysable group, an open ring polymerizable reactive group, a group having an active hydrogen atom, an isocyanate group, a formyl group, a methylol group, and an acid anhydride group are preferable, and an alkoxysilyl group, an epoxy group, a hydroxyl group, a carboxyl group, an amino group, a silanol group, an isocyanate group, a formyl group, and a methylol group are particularly preferable.

The plural crosslinkable groups included in the polyfunctional compound may be identical to or different from each other. Types and the number of the crosslinkable groups may be appropriately selected according to other insulating materials, the auxiliary metal wiring that is in contact with the electron transport layer, the negative electrode, the material of the photoelectric conversion layer, and the coating method.

Here, in a case where the crosslinkable group are the same type with each other, the crosslinkable group also include different crosslinkable groups having the same basic structure (for example, hydroxysilyl groups and alkoxysilyl groups), in addition to completely the same crosslinkable groups.

Examples of the polyfunctional compound include various types of metal alkoide, a silane coupling agent, a polyfunctional epoxy monomer, a polyfunctional isocyanate monomer, a polyfunctional (meth)acryl monomer, polyfunctional aldehyde, and a methylol melamine derivative.

Examples of the silane coupling agent include a silane coupling agent containing an amino group, a silane coupling agent containing a vinyl group, a silane coupling agent containing an epoxy group, a silane coupling agent containing a mercapto group, a silane coupling agent containing an isocyanate group, and a silane coupling agent containing a (meth)acryl group.

Specific examples thereof include hydroxymethylmethyldiethoxysilane, N-(methyldiethoxysilylpropyl)-O-polyethylene oxide urethane, N-(3-methyldiethoxysilylpropyl)-4-hydroxybutylamide, N-(3-methyldiethoxysilylpropyl)gluconamide, vinylmethyldimethoxysilane, vinylmethyldiethoxysilane, vinylmethyldibutoxysilane, vinylmethylbis(2-methoxyethoxy)silane, vinyldecylmethyldimethoxysilane, vinyloctylmethyldimethoxysilane, vinylphenylmethyldimethoxysilane, 2-(meth)acryloxyethylmethyldimethoxysilane, 2-(meth)acryloxyethylmethyldiethoxysilane, 3-(meth)acryloxypropylmethyldimethoxysilane, 3-(meth)acryloxypropylmethyldiethoxysilane, 3-(meth)-acryloxypropylmethylbis(2-methoxyethoxy)silane, 3-(vinylphenylamino)propylmethyldimethoxysilane, 3-(vinylphenylamino)propylmethyldiethoxysilane,
3-(vinylbenzylamino)propylmethyldiethoxysilane,
3-(vinylbenzylamino)propylmethyldiethoxysilane, and 3-[2-(N-vinylphenylmethylamino)ethylamino]propylmethyldimethoxysilane.

Specific examples thereof include 3-[2-(N-isopropenylphenylmethylamino)ethylamino]propylmethyldimethoxysilane, 2-(vinyloxy)ethylmethyldimethoxysilane, 3-(vinyloxy)propylmethyldimethoxysilane, 4-(vinyloxy)butylmethyldiethoxysilane, 3-[(meth)acryloxypropyl]methyldimethoxysilane, 3-[(meth)aciyloxypropyl]methyldiethoxysilane,
3-[(meth)acryloxymethyl]-3-[(meth)acryloxymethyl]methyldiethoxysilane, γ-glycidoxypropylmethyldimethoxysilane,
N-[3-(meth)acryloxy-2-hydroxypropyl]-3-aminopropylmethyldiethoxysilane, O-[(meth)acryloxyethyl]-N-(methyldiethoxysilylpropyl)urethane,
γ-glycidoxypropylmethyldiethoxysilane, β-(3,4-epoxycyclohexyl)ethylmethyldimethoxysilane, γ-aminopropylmethyldiethoxysilane, γ-aminopropylmethyldimethoxysilane, 4-aminobutylmethyldiethoxysilane, 11-aminoundecylmethyldiethoxysilane, m-aminophenylmethyldimethoxysilane, p-aminophenylmethyldimethoxysilane, 3-aminopropylmethylbis(methoxyethoxyethoxy)silane, 2-(methyldimethoxysilylethyl)pyridine, N-(3-methyldimethoxysilylpropyl)pyrrole, 3-(m-aminophenoxy)propylmethyldimethoxysilane, N-(2-aminoethyl)-3-aminopropylmethyldimethoxysilane,
N-(2-aminoethyl)-3-aminopropylmethyldiethoxysilane,
N-(6-aminohexyl)aminomethylmethyldiethoxysilane,
N-(6-aminohexyl)aminopropylmethyldimethoxysilane,
N-(2-aminoethyl)-11-aminoundecylmethyldimethoxysilane,
(aminoethylaminomethyl)phenethylmethyldimethoxysilane,
N-3-[(amino(polypropyleneoxy))]aminopropylmethyldimethoxysilane, n-butylaminopropylmethyldimethoxysilane, N-ethylaminoisobutylmethyldimethoxysilane, N-methylaminopropylmethyldimethoxysilane,
N-phenyl-γ-aminopropylmethyldimethoxysilane,
N-phenyl-γ-aminomethylmethyldiethoxysilane,
(cyclohexylaminomethyl)methyldiethoxysilane,
N-cyclohexylaminopropylmethyldimethoxysilane,
bis(2-hydroxyethyl)-3-aminopropylmethyldiethoxysilane,
diethylaminomethylmethyldiethoxysilane, diethylaminopropylmethyldimethoxysilane, dimethylaminopropylmethyldimethoxysilane,
N-3-methyldimethoxysilylpropyl-m-phenylenediamine,
N,N-bis[3-(methyldimethoxysilyl)propyl]ethylenediamine,
bis(methyldiethoxysilylpropyl)amine, bis(methyldimethoxysilylpropyl)amine, bis[(3-methyldimethoxysilyl)propyl]-ethylenediamine, bis[3-(methyldiethoxysilyl)propyl]urea, and bis(methyldimethoxysilylpropyl)urea.

Specific examples thereof include N-(3-methyldiethoxysilylpropyl)-4,5-dihydroimidazole, ureidopropylmethyldiethoxysilane, ureidopropylmethyldimethoxysilane, acetamidepropylmethyldimethoxysilane, 2-(2-pyridylethyl)thiopropylmethyldimethoxysilane,
2-(4-pyridylethyl)thiopropylmethyldimethoxysilane,
bis[3-(methyldiethoxysilyl)propyl]disulfide, 3-(methyldiethoxysilyl)propylsuccinic anhydride, γ-mercaptopropylmethyldimethoxysilane, γ-mercaptopropylmethyldiethoxysilane, isocyanatopropylmethyldimethoxysilane, isocyanatopropylmethyldiethoxysilane, isocyanatoethylmethyldiethoxysilane, isocyanatomethylmethyldiethoxysilane, carboxyethylmethylsilanediol sodium salt, N-(methyldimethoxysilylpropyl)ethylenediamine triacetic acid trisodium salt, 3-(methyldihydroxysilyl)-1-propanesulfonic acid, diethylphosphateethylmethyldiethoxysilane, 3-methyldihydroxysilylpropylmethylphosphonate sodium salt, tris(3-methyldimethoxysilylpropyl)isocyanurate, N,N'-bis(hydroxyethyl)-N,N'-bis(methyldimethoxysilylpropyl)ethylenediamine,
bis[N,N'-(methyldiethoxysilylpropyl)aminocarbonyl]polyethylene oxide, hydroxymethyltriethoxysilane, N-(triethoxysilylpropyl)-O-polyethylene oxide urethane, N-(3-triethoxysilylpropyl)-4-hydroxybutylamide, N-(3-triethoxysilylpropyl)gluconamide, vinyltrimethoxysilane, vinyltriethoxysilane, vinyltributoxysilane, vinyltris(2-methoxyethoxy)silane, vinyldecyltrimethoxysilane, vinyloctyltrimethoxysilane, vinylphenyltrimethoxysilane, 2-(meth)acryloxyethyltrimethoxysilane, 2-(meth)acryloxyethyltriethoxysilane, 3-(meth)acryloxypropyltrimethoxysilane, 3-(meth)acryloxypropyltrimethoxysilane,
3-(meth)-acryloxypropyltris(2-methoxyethoxy)silane,
3-(vinylphenylamino)propyltrimethoxysilane, 3-(vinylphenylamino)propyltriethoxysilane, 3-(vinylbenzylamino)propyltriethoxysilane, 3-(vinylbenzylamino)propyltriethoxysilane, 3-[2-(N-vinylphenylmethylamino)ethylamino]propyltrimethoxysilane,
3-[2-(N-isopropenylphenylmethylamino)ethylamino]propyltrimethoxysilane, 2-(vinyloxy)ethyltrimethoxysilane, 3-(vinyloxy)propyltrimethoxysilane, 4-(vinyloxy)butyltriethoxysilane, 3-[(meth)acryloxypropyl]trimethoxysilane, 3-[(meth)acryloxypropyl]triethoxysilane, 3-[(meth)acryloxymethyl]trimethoxysilane, 3-[(meth)acryloxymethyl]triethoxysilane, γ-glycidoxypropyltrimethoxysilane, N-[3-(meth)acryloxy-2-hydroxypropyl]-3-aminopropyltriethoxysilane,
O-[(meth)acryloxyethyl]-N-(triethoxysilylpropyl)urethane, 3-glycidoxypropyltrimethoxysilane, 3-glycidoxypropyltriethoxysilane, and β-(3,4-epoxycyclohexyl)ethyltrimethoxysilane.

Specific examples thereof include γ-aminopropyltriethoxysilane, γ-aminopropyltrimethoxysilane, 4-aminobutyltriethoxysilane, 11-aminoundecyltriethoxysilane, m-aminophenyltrimethoxysilane, p-aminophenyltrimethoxysilane, 3-aminopropyltris(methoxyethoxyethoxy)silane, 2-(trimethoxysilylethyl)pyridine, N-(3-trimethoxysilylpropyl)pyrrole, 3-(m-aminophenoxy)propyltrimethoxysilane, N-(2-aminoethyl)-3-aminopropyltrimethoxysilane,
N-(2-aminoethyl)-3-aminopropyltriethoxysilane,
N-(6-aminohexyl)aminomethyltriethoxysilane,
N-(6-aminohexyl)aminopropyltrimethoxysilane,
N-(2-aminoethyl)-11-aminoundecyltrimethoxysilane,
(aminoethylaminomethyl)phenethyltrimethoxysilane,
N-3-[(amino(polypropyleneoxy))]aminopropyltrimethoxysilane,
n-butylaminopropyltrimethoxysilane, N-ethylaminoisobutyltrimethoxysilane, N-methylaminopropyltrimethoxysilane, N-phenyl-γ-aminopropyltrimethoxysilane, N-phenyl-γ-aminomethyltriethoxysilane, (cyclohexylaminomethyl)triethoxysilane, N-cyclohexylaminopropyltrimethoxysilane, bis(2-hydroxyethyl)-3-aminopropyltriethoxysilane, diethylaminomethyltriethoxysilane, diethylaminopropyltrimethoxysilane, dimethylaminopropyltrimethoxysilane, N-3-trimethoxysilylpropyl-m-phenylenediamine, N,N-bis[3-(trimethoxysilyl)propyl]ethylenediamine, bis(triethoxysilylpropyl)amine, bis(trimethoxysilylpropyl)amine, bis[(3-trimethoxysilyl)propyl]-ethylenediamine, bis[3-(triethoxysilyl)propyl]urea, bis(trimethoxysilylpropyl)urea, N-(3-triethoxysilylpropyl)-4,5-dihydroimidazole, ureidopropyltriethoxysilane, ureidopropyltrimethoxysilane, and acetamidopropyltrimethoxysilane.

Specific examples thereof include 2-(2-pyridylethyl)thiopropyltrimethoxysilane, 2-(4-pyridylethyl)thiopropyltrimethoxysilane, bis[3-(triethoxysilyl)propyl]disulfide, 3-(triethoxysilyl)propylsuccinic anhydride, 3-mercaptopropyltrimethoxysilane, 3-mercaptopropyltriethoxysilane, isocyanatopropyltrimethoxysilane, isocyanatopropyltriethoxysilane, isocyanatoethyltriethoxysilane, isocyanatomethyltriethoxysilane, carboxyethylsilanetriol sodium salt, N-(trimethoxysilylpropyl)ethylenediamine triacetic acid trisodium salt, 3-(trihydroxysilyl)-1-propanesulfonic acid, diethylphosphateethyltriethoxysilane, 3-trihydroxysilylpropylmethylphosphonate sodium salt, tris(3-trimethoxysilylpropyl)isocyanurate, [hydroxy(polyethyleneoxy)propyl]triethoxysilane, N,N'-bis(hydroxyethyl)-N,N'-bis(trimethoxysilylpropyl)ethylenediamine, and bis[N,N'-(triethoxysilylpropyl)aminocarbonyl]polyethylene oxide.

According to the invention, the combination of the crosslinking group and the crosslinkable group of the polyfunctional compound on the macromolecular compound is not particularly limited, as long as the combination is a combination in which the crosslinking group and the crosslinkable group can perform crosslinking reaction by the common method. Preferable examples thereof include a combination of the silane coupling agent and polyvinylphenol, polyvinylbutyral, or polyvinyl alcohol; a combination of a polyfunctional epoxy monomer and polyvinylphenol, polyvinylbutyral, or polyvinyl alcohol; and a combination of methylol melamine derivative and polyvinylphenol, polyvinylbutyral, or polyvinyl alcohol.

The crosslinking reaction of the macromolecular compound and the polyfunctional compound and the crosslinking structure of the crosslinking macromolecule correspond to the combination of the macromolecular compound and the polyfunctional compound. Though it is not simple to describe, the crosslinking macromolecule is a crosslinking substance obtained by performing crosslinking reaction between the macromolecular compound and the crosslinkable group of the polyfunctional compound, and may be a mesh-shaped macromolecule.

### 2. Polyfunctional compound that reacts with metal material and the like

The crosslinkable group of the polyfunctional compound may be a group that performs crosslinking reaction with the macromolecular compound, but it is preferable that the group also functions as a reactive group that can be chemically bonded to the material for forming the auxiliary metal wiring or the negative electrode when an electron transport layer is provided by a wet film forming method described below. If at least a portion of the crosslinkable group also functions as such a reactive group, even if the solar cell is deformed by handling at the time of the manufacturing or after the manufacturing, heating, cooling, or the like, the generation of defects such as cracks in the electron transport layer can be prevented. The adhesive force with the auxiliary metal wiring or the negative electrode becomes high, such that the interlayer peeling can be suppressed.

Particularly, at the edge part of the auxiliary metal wiring, stress concentrates due to the difference in level of the auxiliary metal wiring, the defect of the electron transport layer is easily generated, the auxiliary metal wiring or the negative electrode is in contact with the respective function layers (the photoelectric conversion layer, the hole transport layer, or the positive electrode) on the electron transport layer, the dark current increases, and as a result, short circuit failure occurs. However, if the polyfunctional compound included in the insulating material for constituting the electron transport layer has at least one reactive group that is chemically bonded to the material of the auxiliary metal wiring or the negative electrode, even if the stress concentrates at the edge part of the auxiliary metal wiring, due to the polyfunctional compound bonded to the negative electrode or the auxiliary metal wiring, the generation of the defects of the electron transport layer can be suppressed, such that flexibility and durability of the solar cell can be improved.

The reactive group is appropriately selected according to the material for forming the auxiliary metal wiring and the negative electrode.

For example, in a case where the auxiliary metal wiring includes various metal materials, among the groups described above, a mercapto group, an amido group, an amino group, a carboxyl group, a sulfonic acid group, a phosphoric acid group, a phosphonic acid group, and the like are preferable, and the polyfunctional compounds having these groups are preferably used.

In a case where the auxiliary metal wiring is formed by the silver salt method, a silyl group that can be chemically bonded (crosslinked) to the hydrophilic polymer or silver, an open ring polymerizable reactive group, a group having an active hydrogen atom, a formyl group, an acid anhydride group, and the like are preferable. The polyfunctional compound preferably uses a compound having any of these groups.

In a case where the auxiliary metal wiring is formed with the metal material and the electron transport material is formed with metal oxide, examples of the reactive group preferably include a combination of a silyl group with at least one reactive group of an amino group, an isocyanate group, an epoxy group, and a mercapto group. As the polyfunctional compound having this combination, various silane coupling agents described above are preferably used.

In the case where the negative electrode includes metal or metal oxide, the reactive group is the same as the auxiliary metal wiring.

### 3. Polyfunctional compound that reacts or that is polymerized with polymer

In a case where the negative electrode includes the conductive macromolecule, the crosslinkable group is preferably a group that reacts with the polymer of the compound having the plural crosslinkable group that is preferably contained in the negative electrode. Among the groups described above, examples of this group include a silyl group having the hydrolysable group, an open ring polymerizable reactive group, a group having an active hydrogen atom, a formyl group, and an acid anhydride group. The polyfunctional compound preferably uses a compound having any of these groups.

### (Forming of electron transport layer)

The electron transport layer can be appropriately formed by any one of a wet film forming method by coating or the like and a dry film forming method by a PVD method such as vapor deposition, sputtering, a transfer method, a printing method, or the like.

With respect to a wet film forming method, a film can be formed by applying a coating liquid containing a crosslinking macromolecule crosslinked in advance and hardening the coating liquid and also can be formed by applying a coating liquid containing the macromolecular compound and the polyfunctional compound and hardening (performing crosslinking reaction) the coating liquid.

In a case where a silicon resin is used as a macromolecular compound, a monomer for forming a silicon resin as the polyfunctional compound can be used. In this case, the silicon resin polymerized in advance and the silane coupling agent as the polyfunctional compound can be used, and as the monomer for forming the silicon resin and the polyfunctional compound, one or two or more types of silane coupling agents can be used.

According to the invention, in addition to the flexibility of the electron transport layer, in view of adhesive force with the negative electrode or the auxiliary metal wiring, it is preferable to apply the coating liquid containing the macromolecular compound and the polyfunctional compound and heating and hardening (performing crosslinking reaction, polymerizing reaction, or the like) the coating liquid.

This coating liquid contains one or more types of the macromolecular compounds and one or more types of the polyfunctional compounds.

The polyfunctional compound and other insulating materials may be combined. In a case where the crosslinkable group of the polyfunctional compound and crosslinking groups of the other insulating materials are crosslinked (polymerized) to form a mesh-shaped macromolecule, the polyfunctional compound may be called a crosslinking agent or a hardening agent.

The film thickness of the electron transport layer is generally about 0.1 to 500 nm and preferably 0.5 to 300 nm.

### <Porous layer>

The porous layer 17 is preferably provided between the electron transport layer 14 and the photoelectric conversion layer 15.

The porous layer 17 is a layer that functions as a stage for carrying the material for forming the photoelectric conversion layer 15 to the surface and a fine particle layer having fine holes which is obtained by accumulating porous materials, and the porous layer 17 is designed according to the purpose. The porous layer 17 may be a fine particle layer obtained by accumulating one type of porous material and may be a fine particle layer obtained by accumulating two or more porous materials.

The porous layer 17 increases the adsorption amount of the material for forming the photoelectric conversion layer 15 by fine particles having having fine holes. In order to increase light absorption efficiency, it is preferable to increase a surface area of at least a portion that receives light such as sun light, and thus it is preferable to increase the entire surface area of the porous layer 17, that is, to increase the surface areas of the respective fine particles.

According to the invention, in a state in which the electron transport layer 14 is coated with the coating liquid including the fine particles for forming the porous layer, the surface area of the fine particles is preferably 10 times or greater with respect to the projected area.

In a case where the photoelectric conversion layer 15 described below is formed by a wet method, the coating liquid easily introduced to the porous layer 17, the photoelectric conversion material may be adsorbed into the deep portion of the porous layer 17. In this case also, if the electron transport layer contains the crosslinking macromolecule, cracks are hardly generated, and thus short circuit can be prevented.

The film thickness of the porous layer 17 is not particularly limited, but the film thickness is in the range of 0.1 to 100 µm, preferably 0.2 to 10 µm, and more preferably 0.3 to 1 µm.

With respect to the conductivity, the material for forming the porous layer 17 is not particularly limited. The material may be an insulating material or a conductive or semi-conductive material.

As the material for forming the porous layer 17, for example, chalcogenide of metal (for example, oxide, sulfide and selenide), a compound having a perovskite structure (except for a material for forming the photoelectric conversion layer described below), fine particles of oxide of silicon, or carbon nanotubes can be used.

The chalcogenide of metal is not particularly limited, but examples thereof preferably include respective oxide such as titanium, tin, zinc, tungsten, zirconium, hafnium, strontium, indium, cerium, yttrium, lanthanum, vanadium, niobium, aluminum, or tantalum, cadmium sulfide, and cadmium selenide. Examples of the crystal structure of the chalcogenide of metal include an anatase type, a brookite type, or a rutile type, and an anatase type and a brookite type are preferable.

The compound having the perovskite structure is not particularly limited, but examples thereof include transition metal oxide. Specific examples thereof include strontium titanate, calcium titanate, barium titanate, lead titanate, barium zirconate, barium titanate, lead zirconate, strontium zirconate, strontium tantalate, potassium niobate, bismuth ferrite, strontium barium titanate, barium lanthanum titanate, calcium titanate, sodium titanate, and bismuth titanate, and preferable examples thereof include strontium titanate, and calcium titanate.

Examples of the material for forming the porous layer 17 include oxide of silicon (for example, silicon dioxide, zeolite) and carbon nanotubes (including carbon nanowire and carbon nanorod).

The carbon nanotube has a carbon film (graphen sheet) in a cylindrically rounded shape, and is classified into a single layer carbon nanotube in which one sheet of graphen sheet is rounded in a cylindrical shape, a double layer carbon nanotube in which two sheets of graphen sheets are rounded in a concentric shape, and multilayer carbon nanotube (MWCNT) in which plural graphen sheets are rounded in a concentric shape. According to the invention, carbon nanotubes are not particularly limited, and any carbon nanotubes can be used.

Among these, the material for forming the porous layer 17 is preferably respective oxides of titanium, tin, zinc, zirconium, aluminum, or silicon or carbon nanotubes, and even more preferably titanium oxide, zinc oxide, or aluminum oxide.

The porous layer 17 may be formed with at least one type of chalcogenide of metal, a compound having a perovskite structure, oxide of silicon, and carbon nanotubes or may be formed with plural types thereof described above. Nanotubes, nanowire, or nano rods of these materials can be used together with fine particles of these materials.

The material for forming the porous layer 17 is preferably used as fine particles, even more preferably used as dispersion containing fine particles. The particle diameter of the fine particles at this point is 0.001 to 1 µm as primary particles in an average particle diameter using a diameter when the projected area is converted to a circle and preferably 0.01 to 100 µm as an average particle diameter of the dispersion.

### <Photoelectric conversion layer>

The photoelectric conversion layer 15 is constituted by being selected from a material that highly efficiently exhibits a photoelectric conversion step in which after exciton (electron-hole pair) is generated by receiving visible light such as sunlight, this exciton is decomposed into an electron and a hole, and the electron is transported to the negative electrode 12 side, and the hole is transported to the positive electrode 16.

In a case where an organic thin film solar cell is formed, a photoelectric conversion layer including an electron-donating region (doner) consisting of an organic material is formed, and, in view of conversion efficiency, a photoelectric conversion layer (hereinafter, also referred to as "bulkhetero layer") of a bulkhetero junction type is preferable.

Meanwhile, as the material for forming the photoelectric conversion layer 15, a compound having a perovskite structure is preferable.

The bulk hetero layer is a photoelectric conversion layer consisting of an organic material in which electron-donating materials (doners) and electron accepting materials (acceptors) are mixed. The mixture ratio of the electron-donating material and the electron accepting material is adjusted such that the conversion efficiency becomes high, but generally selected from the range of 10:90 to 90:10 by a mass ratio. As the method for forming such a mixture layer, for example, a co-vapor deposition method is used. Otherwise, the mixture layer can be manufactured by performing solvent coating by using a solvent that dissolves both organic materials.

The film thickness of the bulk hetero layer is preferably 10 to 500 nm and particularly preferably 20 to 300 nm.

The electron-donating material (also referred to as a doner or a hole transport material) is a π electron conjugated compound of which the highest occupied molecular orbit (HOMO) level is 4.5 to 6.0 eV.

Specifically, a conjugated polymer in which various types of arene (for example, thiopene, carbazole, fluorene, silafluorene, thienopyrazine, thienobenzothiopene, dithienosilole, quinoxaline, benzothiadiazole, and thienothiopene) are coupled, a phenylenevinylene-based polymer, porphyrins, phthalocyanines, and the like are exemplified. In addition, compound groups disclosed as Chemical Reviews., Vol. 107, pages 953 to 1010 (2007) as "Hole-Transporting Materials" or porphyrin derivatives disclosed in Journal of the American Chemical Society., Vol. 131, page 16048 (2009) can be also applied.

Among these, a conjugated polymer in which a constitutional unit selected from the group consisting of thiopene, carbazole, fluorene, silafluorene, thienopyrazine, thienobenzothiopene, dithienosilole, quinoxaline, benzothiadiazole, and thienothiopene is coupled is particularly preferable. Specific examples thereof include poly-3-hexylthiopene (P3HT), poly-3-octylthiopene (P3OT), various polythiopene derivatives disclosed in Journal of the American Chemical Society., Vol. 130, page 3020 (2008), PCTBT disclosed in Advanced Materials., Vol. 19, page 2295 (2007), PCDTQx, PCDTPP, PCDTPT, PCDTBX, and PCDTPX disclosed in Journal of the American Chemical Society., Vol. 130, page 732 (2008), and PBDTTT-E, PBDTTT-C, and PBDTTT-CF disclosed in Nature Photonics., Vol. 3, page 649 (2009), and PTB7 disclosed in Advanced Materials., Vol. 22, pages E135 to E138 (2010).

The electron accepting material (also referred to as an acceptor or an electron transport material) is a n electron conjugated compound of which the lowest unoccupied molecular orbital (LUMO) is 3.5 to 4.5 eV.

Specific examples thereof include fullerene and derivatives thereof, a phenylenevinylene-based polymer, naphthalenetetracarboxylic acid imide derivatives, and perylenetetracarboxylic acid imide derivatives. Among these, fullerene derivatives are preferable. Specific examples of the fullerene derivative include C₆₀, phenyl-C₆₁-methyl butyrate ester (fullerene derivative referred to as PCBM, [60]PCBM, or PC₆₁BM in documents), C₇₀, phenyl-C₇₁-methyl butyrate ester (fullerene derivative referred to as PCBM, [70]PCBM, or PC₇₁BM in many documents), fullerene derivatives disclosed in Advanced Functional Materials., Vol. 19, pages 779 to 788 (2009), fullerene derivative SIMEF disclosed in Journal of the American Chemical Society., Vol. 131, page 16048 (2009), and fullerene derivative ICBA disclosed in Journal of the American Chemical Society., Vol. 132, page 1377 (2010).

The compound having the perovskite structure is not particularly limited, as long as the compound has a perovskite structure, and the compound expressed by Formula (I) below is preferable.

Formula (I): R¹-NH₃MX₃

In the formula, R¹ represents an alkyl group, an alkenyl group, an alkynyl group, an aryl group, or a heteroaryl group. M represents a metal atom. X represents an atom or an atom group that becomes an anion.

The alkyl group is preferably an alkyl group having 1 to 6 carbon atoms, and examples thereof include methyl, ethyl, propyl, isopropyl, butyl, tert-butyl, pentyl, and hexyl. The alkenyl group is preferably an alkenyl group having 2 to 6 carbon atoms, and examples thereof include vinyl, allyl, butenyl, and hexenyl. The alkynyl group is preferably an alkynyl group having 2 to 6 carbon atoms, and examples thereof include ethynyl, butynyl, and hexynyl.

The aryl group is preferably an aryl group having 6 to 14 carbon atoms, and examples thereof include phenyl.

With respect to the heteroaryl group, a heteroatom for constituting a heterocyclic ring thereof is preferably a nitrogen atom, an oxygen atom, or a sulfur atom, the ring members is preferably a 5-membered ring or a 6-membered ring, or may be ring-condensed with an aromatic ring, an aliphatic ring, or a heterocyclic ring.

Examples of the 5-membered ring that constitutes the heteroaryl group include a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. Examples of the 6-membered ring include a pyridine ring, a pyrimidine ring, a pyrazine ring, a triazine ring, a quinoline ring, and a quinazoline ring.

An alkyl group, an alkenyl group, an alkynyl group, an aryl group, or a heteroaryl group may have a substituent. The substituent is not particularly limited, and examples thereof include an alkyl group, an alkenyl group, an alkynyl group, an aryl group, an heterocyclic ring group, an alkoxyl group, an alkylthio group, an amino group, an alkylamino group, an arylamino group, an acyl group, an alkoxycarbonyl group, an aryloxycarbonyl group, an acylamino group, a sulfoneamido group, a carbamoyl group, a sulfamoyl group, a halogen atom, a cyano group, a hydroxy group, or a carboxy group.

When there are plural substituents, the respective substituents may be identical to or different from each other. When plural substituents are close to each other (particularly, are adjacent to each other), the substituents may be connected to each other to form a ring. Rings, for example, alicyclic rings, aromatic rings, and heterocyclic rings may form a fused ring obtained by condensing these rings. According to the invention, the respective substituents may be further substituted with a substituent.

M represents a metal atom and preferably any metal atom that has a perovskite structure, but particularly preferably lead or tin. M may be one type of metal atom or may be two or more types of metal atoms. In a case where there are two or more metal atoms, two types of lead and tin are preferable. A ratio of including metal atom at this point is not particularly limited.

X represents an atom or an atomic group that becomes an anion and is preferably an atom, and examples thereof include a halogen atom. Examples of the halogen atom include a fluorine atom, a chlorine atom, a bromine atom, and an iodine atom. X may be one type of atom or atomic group or may be two or more atoms or atomic groups. In a case of two or more atoms or atomic groups, X is preferably two types of halogen atoms, particularly a combination of a chlorine atom and an iodine atom or a combination of a bromine atom and an iodine atom. The ratio of the atom or the atomic group at this point is not particularly limited.

According to the invention, the compound expressed by Formula (I) may be used singly or plural types thereof may be used.

Hereinafter, specific examples of the compound expressed by Formula (I) are provided, but the invention is not limited thereto. All compounds described below may have perovskite structures.

CH₃NH₃PbCl₃, CH₃NH₃PbBr₃, CH₃NH₃PbI₃, CH₃NH₃PbBrI₂, CH₃NH₃PbBr₂I, C₂H₅NH₃PbI₃, CH₂=CHNH₃PbI₃, CH≡CNH3PbI₃, n-C₃H₇NH₃PbI₃, n-C₄H₉NH₃PbI₃, C₆H₅NH₃PbI₃, C₆H₃F₂NH₃PbI₃, C₆F₅NH₃PbI₃, C₄H₃SNH₃PbI₃, CH₃NH₃SnBr₃, and CH₃NH₃SnI₃

Here, C₄H₃SNH₃ in C₄H₃SNH₃PbI₃ is 2-aminothiazole.

The compound having a perovskite structure represented by Formula (I) can be synthesized from MX₂ and R¹-NH₃X (for example, see WO2013/171517A).

The usage amount of the compound having a perovskite structure represented by Formula (I) may be an amount in which at least a light incident surface among the surface of the porous layer 17 or preferably the entire surface of the porous layer 17 is covered. Examples of the amount is preferably 1.0 × 10⁻³ to 1.0 × 10⁸ mmol, more preferably 1.0 × 10⁻² to 1.0 × 10⁶ mmol, and particularly preferably 1.0 × 10⁻¹ to 1.0 × 10⁵ mmol, per 1 m² of the surface area of the support 11, overall.

The photoelectric conversion layer 15 may be a single layer or may be a laminate of two or more layers.

### <Hole transport layer>

The hole transport layer 22 is preferably formed on the photoelectric conversion layer 15.

Examples of the hole transport material used in the hole transport layer include electron-donating materials exemplified in the photoelectric conversion layer 15 described above, copper thiocyanate, and copper iodide. Various types of metal oxide also used as the material of the hole transport layer having high stability. For example, vanadium oxide, molybdenum oxide, and tungsten oxide are preferable. The conductive macromolecule included in the negative electrode 12 described above is preferable as a stable hole transport material.

In view of flexibility, the hole transport layer preferably contains a polymer of a compound having plural crosslinkable groups in the same manner as the negative electrode.

The film thickness of the hole transport layer is generally about 0.1 to 500 nm and preferably 0.5 to 300 nm.

The hole transport layer can be appropriately formed by any one of a wet film forming method using coating, a dry film forming method using a PVD method such as vapor deposition or sputtering, a transfer method, and a printing method.

### <Positive electrode>

The positive electrode 16 is provided on the hole transport layer 22.

The material for forming the positive electrode is not particularly limited, but examples thereof include metal such as chromium, cobalt, nickel, copper, molybdenum, palladium, silver, tantalum, tungsten, platinum, and gold, an alloy thereof, TCO exemplified in the negative electrode 12 described above, or a conductive macromolecule. Such metal, TCO, and a conductive macromolecule are may be used singly, two or more types thereof may be used in a mixture, or a laminate of two or more layers may be used. If the metal material is used, the light that arrives at the metal electrode is reflected to the photoelectric conversion layer 15 side, and the reflected light is absorbed back. Therefore, the photoelectric conversion efficiency improves, and thus it is preferable.

The forming method of the positive electrode 16 is not particularly limited, and is performed by the well-known methods. The positive electrode 16 can be formed by a method appropriately selected, for example, from a wet film forming method using coating or printing, a PVD method such as a vacuum vapor deposition method, a sputtering method, and an ion plating method, a dry film forming method using various types of chemical vapor deposition (CVD method), considering the aptitude with the constitutional materials described above.

Patterning when the positive electrode is formed may be performed by chemical etching by photolithography, may be performed by physical etching by laser or the like, may be performed by vacuum vapor deposition or sputtering by overlapping shadow masks, or may be performed by a lift-off method or a printing method.

The positive electrode is preferably formed by a printing method that can be patterned at a certain position, in view of the reduction of manufacturing cost. Examples of the printing method include printing methods such as letterpress printing, screen printing, lithographic printing, intaglio printing, stencil printing, and an inkjet method.

The inkjet method is a method of jetting electrode materials from an inkjet head so as to perform patterning. As the jetting method from the inkjet head, well-known methods such as inkjet methods in an on-demand type such as a piezo type or a thermal type or a continuous jet type such as an electrostatic attraction method can be used so as to perform patterning.

After coating, if necessary, a solvent in a coated film can be removed by performing a heating treatment or a light irradiation treatment. In a case where precursors (metal salt or metal fine particles) of the electrode material are printed, conductivity can be exhibited by a heating treatment or a light irradiation treatment. The heating treatment and the light irradiation treatment may be performed singly or both treatments may be performed at the same time. Otherwise, one of the treatments is performed and then the other treatment may be performed.

The thickness of the positive electrode is not particularly limited, but the thickness is preferably 0.01 to 10 µm and even more preferably 0.05 to 2 µm.

According to the invention, the electron transport layer having flexibility is provided as described above, and thus the short-circuit of the solar cell can be prevented if the positive electrode is formed by a printing method.

### <Protective layer>

The protective layer 23 may be provided in the solar cell according to the invention.

Examples of the material for forming the protective layer include metal oxide such as magnesium oxide, aluminum oxide, silicon oxide (SiOₓ), titanium oxide, germanium oxide, yttrium oxide, zirconium oxide, and hafnium oxide, metal nitride such as silicon nitride (SiNₓ), metal nitroxide (metal oxide nitride) such as silicon nitride oxide (SiOₓN_{y}), metal fluoride such as lithium fluoride, magnesium fluoride, aluminum fluoride, and calcium fluoride, and an inorganic material such as diamond-like carbon (DLC). Examples of the organic material include polymers such as polyethylene, polypropylene, polyvinylidene fluoride, polyparaxylylene, and polyvinyl alcohol. Among these, oxide of metal, nitride, nitroxide or DLC is preferable, and silicon, oxide of aluminum, nitride, and nitroxide are particularly preferable. The protective layer may be a single layer or may have a multilayer constitution.

The method for forming the protective layer is not particularly limited. For example, a PVD method such as a vacuum vapor deposition method, a sputtering method, an molecular beam epitaxial (MBE) method, a cluster ion beam method, an ion plating method, and a plasma polymerizing method, various CVD methods including an atom layer accumulating method (ALD method or ALE method), a coating method, a printing method, and a transfer method can be applied.

### <Gas barrier layer>

A protective layer for the purpose of preventing permeation of active factors such as water molecules or oxygen molecules is particularly referred to as a gas barrier layer, and the solar cell preferably has the gas barrier layer 21. Particularly, in a case where this gas barrier layer 21 is formed directly on the support 11, the gas barrier layer 21 is preferably formed on the support 11 side from the negative electrode 12.

The gas barrier layer 21 is not particularly limited, as long as the gas barrier layer 21 is a layer blocking active factors such as water molecules or oxygen molecules. However, the materials exemplified as the protective layer 23 above are generally used. These materials may be pure substances or may be mixtures consisting of plural compositions or gradient compositions. Among these, silicon, oxide of aluminum, nitride, and nitroxide are preferable.

The gas barrier layer 21 may be a single layer or plural layers. An organic material layer and an inorganic material layer are laminated, or plural inorganic material layers and plural organic material layers are alternatively laminated. The organic material layer is not particularly limited, as long as the organic material layer has smoothness, but a layer consisting of a polymer (acryl polymer) of (meth)acrylate is preferably exemplified. The thickness of the organic material layer is not particularly limited, but the thickness of one layer is preferably 0.3 to 3 µm.

The inorganic material layer is preferably the material for forming the protective layer described above and particularly preferably silicon, oxide of aluminum, nitride, and nitroxide. The thickness of the inorganic material layer is not particularly limited, but the thickness of one layer is generally preferably 5 to 500 nm and even more preferably 10 to 200 nm. The inorganic material layer may have a laminate structure achieved from plural sub-layers. In this case, the respective sub-layers may have the same composition or may have different compositions. As disclosed in US2004/0046497A, the inorganic material layer may be a layer of which an interface with the organic material layer consisting of the polymer is not clear and the composition continuously changes in the film thickness direction.

The thickness of the entire gas barrier layer is not particularly limited, but the thickness is preferably 0.1 to 20 µm and more preferably 0.3 to 10 µm.

### <Sealing film>

According to the invention, the sealing film 25 is preferably provided on the positive electrode 16 or the protective layer 23. The sealing film 25 preferably functions as a second support.

In the same manner as the gas barrier layer 21, the sealing film 25 is suitably provided so as to prevent substances that deteriorate the photoelectric conversion layer 15 (photoelectric conversion material) such as water or oxygen from permeating the photoelectric conversion layer 15.

With respect to the sealing film 25, for example, a constitution in which the material exemplified as the protective layer 23 above is formed to be the gas barrier layer on a polyethylene terephthalate (PET) film or a PEN film is exemplified. These materials may be pure substances or may be a mixture consisting of plural compositions or may be a gradient composition. Among these, oxide of silicon or aluminum, nitride, and nitroxide are preferable.

The sealing film 25 may be provided on the adhesive layer 24 by the well-known methods such as adhesion by adhesive, heat seal to the protective layer via various sealant materials, or vacuum heating laminate.

The adhesive is not particularly limited, but, for example, emulsion type adhesive, adhesive for wax hot melt lamination, and adhesive for dry lamination are preferable. Examples of the adhesive of the emulsion type include a coating agent in which thermoplastic elastomer, low density polyethylene (LDPE), an ionomer (IO), a polyvinylidene chloride resin (PVDC), polyethylene (PE) wax, and the like are dispersed.

Examples of the adhesive for the wax hot melt lamination include PVDC coated OPP (a biaxial stretching polypropylene film, a nylon film, a PET film, and a polyvinyl alcohol (PVA) film).

Examples of the adhesive (sealant material) for dry lamination include a vinyl chloride-vinyl acetate copolymer, an ethylene-vinyl acetate copolymer (EVA), an ethylene-vinyl alcohol copolymer, polyvinylidene chloride, nitro cellulose, cellulose acetate, an ionomer resin, and a silicone resin.

In a case where a gas barrier layer or the like is formed, it is preferable that a sealing film is provided on the protective layer 23 such that the gas barrier layer or the like becomes an inner side (the photoelectric conversion layer 15 side).

It is preferable that the sealing film is provided on the support 11.

A surface function layer may be provided on the outer side (an opposite side of the protective layer 23) of the sealing film 25, if necessary. Examples of the surface function layer include a matting agent layer, an antireflection layer, a hardcoat layer, an antifogging layer, an antifouling layer, and an easily adhesive layer. In addition to this, the surface function layer is specifically disclosed in JP2006-289627A.

### Examples

Hereinafter, the invention is described in detail with reference to examples, but the invention is not limited thereto.

### Example 1

In Example 1, the solar cell 1A illustrated in Fig. 1 was manufactured, and decrease ratios (durability) of photoelectric conversion efficiency before and after the folding were evaluated.

### (Manufacturing of solar cell No. 101)

A solar cell No. 101 was manufactured in the order described below.

### (Forming of gas barrier layer 21)

A PEN film as the support 11 was coated with a polymerizable composition in the composition below using a wire bar. Thereafter, an ultraviolet ray (radiant exposure: 1 J·cm⁻²) was applied using a high pressure mercury lamp in the dry nitrogen, so as to form an acrylate polymer layer (film thickness: 1.5 µm).

Thereafter, an aluminum oxide layer (film thickness: 0.04 µm) was formed on an acrylate polymer layer in an atmosphere in which Ar gas and O₂ gas were introduced at a degree of vacuum of 0.1 Pa by direct current sputtering.

The film forming steps of the acrylate polymer layer and the aluminum oxide layer were alternatively performed respectively three times, so as to form the gas barrier layer 21 of which an outermost surface is an aluminum oxide layer.

**(Composition of polymerizable composition)**

| | |
|---|---|
| • Trimethylolpropane triacrylate (TMPTA) | 6 g |
| • Epoxy acrylate (EBECRYL 3702 (Product Name) manufactured by Daicel-Allnex Ltd.) | 13 g |
| • Methacrylate phosphate (KAYAMER PM-21 (Product Name) manufactured by Nippon Kayaku Co., Ltd.) | 1 g |
| • Photopolymerization initiator (Esacure KTO 46 (Product Name) manufactured by Lamberti S.p.A.) | 0.5 g |
| • 2-Butanone (MEK) | 190 g |

### (Forming of the transparent negative electrode 12)

An ITO layer (film thickness: 0.1 µm) as the transparent negative electrode 12 was formed on the surface (on the aluminum oxide layer) of the PEN film on which the gas barrier layer 21 was formed in an atmosphere in which Ar gas and O₂ gas were introduced at a degree of vacuum of 0.1 Pa by high frequency magnetron sputtering.

### (Forming of auxiliary metal wiring 13)

Vacuum vapor deposition was performed with silver (film thickness: 0.1 µm) on the ITO layer 12, so as to form the auxiliary metal wiring 13. At this point, two steps of vapor deposition were performed by using a stripe metal mask with an opening width of 0.3 mm and a pitch of 2.5 mm, so as to form the square grid-shaped auxiliary metal wiring 13 (opening ratio: 77%).

### (Forming of the electron transport layer 14)

After the auxiliary metal wiring 13 and the ITO layer 12 were rotary-coated with an ethanol solution containing 3-glycidoxypropyltrimethoxysilane (0.2 mass%), 3-mercaptopropyltrimethoxysilane (0.2 mass%), poly(4-vinylphenol) (PVP, Mw = 11,000, 0.5 mass%), and zinc acetylacetonate monohydrate (Zn(acac)₂, 8 mass%), a heating treatment was performed at 140°C for one hour, so as to form a zinc oxide layer as the electron transport layer 14 (film thickness: 0.1 µm) including crosslinking PVP crosslinked by 3-glycidoxypropyltrimethoxysilane and 3-mercaptopropyltrimethoxysilane as crosslinking agents.

### (Forming of the photoelectric conversion layer 15)

The surface (the electron transport layer 14) of the PEN film was irradiated with ultraviolet rays (radiant exposure: 5 J·cm⁻²) by using a low pressure mercury lamp, and the surface of the electron transport layer 14 was dry-cleaned.

The electron transport layer 14 was rotary-coated with an anisole (20 mass%) mixed toluene solution including P3HT (lisicon SP001 (Product Name) manufactured by Merck & Co., Inc., 2 mass%) as an electron-donating material and ICBA (manufactured by Sigma-Aldrich Co., LLC., 2 mass%) as an electron transport material, so as to form the photoelectric conversion layer 15 (film thickness: 0.2 µm).

### (Forming of the hole transport layer 22)

After the photoelectric conversion layer 15 was rotary-coated with an PEDOT-PSS aqueous solution I prepared by mixing a fluorine-based surfactant (Zonyl FS-300 (Product Name) manufactured by Du Pont Kabushiki Kaisha, 1 mass%) and a PEDOT-PSS aqueous solution (Clevios PH 500 (Product Name) manufactured by Heraeus Deutschland GmbH & Co. KG), a heating treatment was performed at 120°C for 15 minutes, so as to form the hole transport layer 22 (film thickness: 0.1 µm).

### (Forming of the positive electrode 16)

Inkjet printing was performed with silver fine particle dispersion liquid (NANOPASTE (Ag) NPS-JL (Product Name) manufactured by Harima Chemicals Group, Inc.), and a heating treatment was performed at 140°C for 15 minutes. This printing step was performed two times in total, so as to form the positive electrode 16 (film thickness: 1.5 µm) consisting of silver.

### (Forming of the protective layer 23)

A silicon nitride oxide (SiOₓN_{y}, film thickness: 0.5 µm) in which composition distribution was changed was formed on the surface (the opposite side of the support 11) of the positive electrode 16 in an atmosphere in which Ar gas, N₂ gas, and O₂ gas were introduced at a degree of vacuum of 1 Pa by high frequency magnetron sputtering, so as to form a protective layer.

### (Bonding of the sealing film 25)

A PEN film in which an aluminum oxide vapor deposition film was formed as the sealing film 25 was laminated on the protective layer 23 by vacuum heating (140°C) with the ethylene-vinyl acetate copolymer (EVA) film (adhesive layer) 24 interposed therebetween as a sealant such that an aluminum oxide vapor deposition film was on the inner side (so as to face the protective layer 23).

According to the steps described above, the solar cell No. 101 having the gas barrier layer 21 was manufactured.

### (Manufacturing of solar cell No. 102)

The gas barrier layer 21, the negative electrode 12, the auxiliary metal wiring 13, and the electron transport layer 14 were formed on the support 11 in the same manner as the manufacturing of the solar cell No. 101.

### (Forming of the photoelectric conversion layer 15)

The surface (the electron transport layer 14) of the PEN film was irradiated with ultraviolet rays (radiant exposure: 5 J·cm⁻²) by a low pressure mercury lamp, such that the surface of the electron transport layer 14 was dry-cleaned.

The electron transport layer 14 was rotary-coated with an N,N-dimethylformamide (DMF) solution including methyl iodide ammonium (1.8 mol·dm⁻³) and lead chloride (II) (0.6 mol·dm⁻³) after being heated at 60°C, and the heating treatment was performed at 100°C for 30 minutes, so as to form a photoelectric conversion layer (film thickness: 0.3 µm) consisting of a compound CH₃NH₃PbI₍₃₋ₓ₎Clₓ having a perovskite structure.

### (Forming of the hole transport layer 22)

The photoelectric conversion layer 15 was rotary-coated with a 2,2',7,7'-tetrakis-(N,N-di-p-methoxyphenylamine)-9,9-spirobifluorene (spiro-OMeTAD, 12 mass%) chlorobenzene solution, obtained by mixing 4-tert-butylpyridine (1 mass%) and an acetonitrile solution (5 mass%) of bis(trifluoromethanesulfonyl) imide lithium (Li-TFSI, 17 mass%), so as to form a spiro-OMeTAD layer (film thickness: 0.05 µm).

Thereafter, the spiro-OMeTAD layer 15 was rotary-coated with a PEDOT-PSS aqueous solution (Clevios PH 500 (Product Name) manufactured by Heraeus Deutschland GmbH & Co. KG) (hereinafter, also referred to as "PEDOT-PSS aqueous solution II") to which 3-glycidoxypropyltrimethoxysilane (1 mass%) and a fluorine-based surfactant (Zonyl FS-300 (Product Name) manufactured by Du Pont Kabushiki Kaisha, 1 mass%) was added, and a heating treatment was performed at 120°C for 15 minutes, so as to form a PEDOT-PSS layer (film thickness: 0.1 µm) including polysiloxane. This hole transport layer 22 consisted of a laminate structure of a spiro-OMeTAD layer and the PEDOT-PSS layer including polysiloxane.

### (Forming of the positive electrode 16, forming of the protective layer 23, and bonding of the sealing film 25)

The positive electrode 16 and the protective layer 23 were formed on the hole transport layer 22 in the same manner as in the solar cell No. 101.

Subsequently, a PEN film on which an aluminum oxide vapor deposition film was formed as the sealing film 25 was laminated on the protective layer 23 by vacuum heating (120°C) with an ionomer resin (HIGH MILAN 1652 (Product Name) manufactured by Du Pont-Mitsui Polychemicals) interposed therebetween as a sealant, such that the aluminum oxide vapor deposition film was on the inner side (so as to face the protective layer 23).

In this manner, a solar cell No. 102 was manufactured.

### (Manufacturing of solar cell No. c101 for comparison)

In the manufacturing of the solar cell No. 101, a solar cell No. c101 was manufactured in the same manner as the manufacturing of the solar cell No. 101, except for forming an electron transport layer by performing rotary-coating with an ethanol solution containing Zn(acac)₂ without adding 3-glycidoxypropyltrimethoxysilane, 3-mercaptopropyltrimethoxysilane, and PVP and performing a heating treatment.

### (Manufacturing of solar cell No. c102 for comparison)

In the manufacturing of the solar cell No. 101, a solar cell No. c102 was manufactured in the same manner as the manufacturing of the solar cell No. 101, except for performing rotary-coating with an ethanol solution containing PVP and Zn(acac)₂ without adding 3-glycidoxypropyltrimethoxysilane and 3-mercaptopropyltrimethoxysilane, performing a heating treatment, and forming an electron transport layer with a zinc oxide layer including non-crosslinking PVP.

### (Manufacturing of solar cell No. c103 for comparison)

In the manufacturing of the solar cell No. 102, a solar cell No. c103 was manufactured in the same manner as the manufacturing of the solar cell No. 102, except for forming an electron transport layer by performing rotary-coating with an ethanol solution containing Zn(acac)₂ without adding 3-glycidoxypropyltrimethoxysilane, 3-mercaptopropyltrimethoxysilane, and PVP and performing a heating treatment.

### (Manufacturing of solar cell No. c104 for comparison)

In the manufacturing of the solar cell No. 102, a solar cell No. c104 was manufactured in the same manner as in the manufacturing of the solar cell No. 102, except for forming an electron transport layer with a zinc oxide layer including a non-crosslinking PVP by performing rotary-coating with an ethanol solution containing PVP and Zn(acac)₂ without adding 3-glycidoxypropyltrimethoxysilane and 3-mercaptopropyltrimethoxysilane and performing a heating treatment.

### (Evaluation of solar cell)

The manufactured respective solar cells were folded, and photoelectric conversion efficiency before and after the folding was measured, so as to evaluate durability.

Specifically, irradiation was performed with pseudo sunlight (radiation illuminance: 80 mW·cm⁻²) from the back surface (side on which a solar cell was not formed) side of the support 11 of each of the solar cells, so as to measure the photoelectric conversion efficiency before folding. That is, while the solar cell was irradiated with light from a light source obtained by combining an air mass filter (84094 (Product Name) manufactured by Newport Corporation) with a xenon lamp (96000 (Product Name) manufactured by Newport Corporation), a voltage was applied by a source meter (Model 2400 (Product Name) manufactured by Keithley Instruments), so as to measure the current value. From the obtained current-voltage characteristics, photoelectric conversion efficiency was calculated by using a Peccell I-V Curve Analyzer (Product Name, manufactured by Peccell Technologies, Inc., ver. 2.1).

Subsequently, as a durability test, after each of the solar cell was curved around a cylindrical bar having a diameter of 1 cm by causing the back surface side of the support 11 of each of the solar cell to be an inner side and immediately removed from the cylindrical bar, so as to be flattened. This operation was repeated 100 times. After each of the solar cell was preserved for 100 hours in a high pressure and high humidity tub at 60°C (relative humidity of 90%), photoelectric conversion efficiency (after folding) was measured.

When the photoelectric conversion efficiency before folding was set to be 1, a relative value of photoelectric conversion efficiency after folding was calculated and evaluated based on criteria below. The results are provided in Table 1 together with results of the other examples.
[S]: Photoelectric conversion efficiency (relative ratio) after durability test was 0.9 or greater
[A]: Photoelectric conversion efficiency (relative ratio) after durability test was 0.8 or greater and less than 0.9
[B]: Photoelectric conversion efficiency (relative ratio) after durability test was 0.6 or greater and less than 0.8
[C]: Photoelectric conversion efficiency (relative ratio) after durability test was less than 0.6

### Example 2

In Example 2, the solar cell 1B illustrated in Fig. 2 was manufactured, and a decrease ratio (durability) of photoelectric conversion efficiency before and after the folding was evaluated.

### (Manufacturing of solar cell No. 201)

In the order described below, a solar cell No. 201 according to the invention was manufactured.

The auxiliary metal wiring 13 was formed on the support 11 by the method (silver salt method) described below.

### (Preparing of silver halide emulsion)

While a solution A described below was maintained at 34°C and was stirred at a high speed by using a stirring and mixing device disclosed in JP1987-160128A (JP-S62-160128A), pH of the solution A was adjusted to 2.95 by using nitric acid (concentration: 6%). Subsequently, a solution B described below and a solution C described below were added to the solution A at a constant flow rate over eight minutes and six seconds by using a double jet method so as to obtain a mixed solution. After the addition was completed, pH of the mixed solution was adjusted to 5.90 by using sodium carbonate (concentration: 5%), and subsequently a solution D and a solution E were added to a mixed solution.

**(Solution A)**

| | |
|---|---|
| Alkali treated inert gelatin (average molecular weight: 100,000) | 18.7 g |
| Sodium chloride | 0.31 g |
| Solution I as below | 1.59 cm³ |
| Pure water | 1.246 cm³ |

**(Solution B)**

| | |
|---|---|
| Silver nitride | 169.9 g |
| Nitric acid (concentration: 6%) | 5.89 cm³ |
| The total amount was set to 317.1 cm³ using pure water. | |

**(Solution C)**

| | |
|---|---|
| Alkali treated inert gelatin (average molecular weight of 100,000) | 5.66 g |
| Sodium chloride | 58.8 g |
| Potassium bromide | 13.3 g |
| Solution I as below | 0.85 cm³ |
| Solution II as below | 2.72 cm³ |
| The total amount was set to 317.1 cm³ using pure water. | |

**(Solution D)**

| | |
|---|---|
| 2-methyl-4-hydroxy-1,3,3a,7-tetraazaindene | 0.56 g |
| Pure water | 112.1 cm³ |

**(Solution E)**

| | |
|---|---|
| Alkali treated inert gelatin (average molecular weight of 100,000) | 3.96 g |
| Solution I as below | 0.40 cm³ |
| Pure water | 128.5 cm³ |

### (Solution I)

10 mass% methanol solution of polyisopropylene polyethyleneoxy disuccinic acid ester sodium salt

### (Solution II)

10 mass% aqueous solution of rhodium hexachloride complex

A deionization and water washing treatment were performed on the solution after the operation was completed, by the common methods at 40°C by a flocculation method. As described below, a solution F and a fungicide were added and dispersed well at 60°C, and pH at 40°C was adjusted to 5.90, so as to obtain a silver chlorobromide cubic particle emulsion finally including 10 mol% of silver bromide and having an average particle diameter of 0.09 µm and coefficient variation of 10%.

**(Solution F)**

| | |
|---|---|
| Alkali treated inert gelatin (average molecular weight of 100,000) | 16.5 g |
| Pure water | 139.8 cm³ |

Chemosensitization was performed on the silver chlorobromide cubic particle emulsion at 40°C for 80 minutes, by using 20 mg of sodium thiosulfate per 1 mol of silver halide, and 500 mg of 4-hydroxy-6-methyl-1,3,3a,7-tetrazaindene (TAI) per 1 mol of silver halide and 150 mg of 1-phenyl-5-mercaptotetrazol per 1 mol of silver halide were added to an emulsion after the chemosensitization was completed, so as to obtain a silver halide emulsion. A volume ratio (silver halide particle/gelatin) of these silver halide particles of the silver halide emulsion to gelatin was 0.625.

### (Coating)

Tetrakis(vinyl sulfonyl methyl)methane was added to a silver halide emulsion as a hardening agent, such that the ratio thereof becomes 200 mg per 1 g of gelatin, di(2-ethylhexyl) sulfosuccinate sodium salt was added as a coating auxiliary agent (surfactant), and surface tension was adjusted, so as to obtain a coating liquid.

After a polyethylene naphthalate (PEN) film (the support 11) provided with an undercoat layer, of which a thickness was 100 µm and the transmittance is 92% (antireflective process on the back surface), was coated with the coating liquid obtained in this manner such that the total weight amount in terms of silver was 0.625 g·m⁻², a cure treatment was performed at 50°C for 24 hours, so as to obtain a photosensitive material.

### (Exposure)

The obtained photosensitive material was exposed by an ultraviolet ray exposure device via a photomask (line width: 5 µm, pitch: 300 µm) of a mesh pattern.

### (Chemical development)

After a development treatment at 25°C for 60 seconds was performed on the exposed photosensitive material by using a development liquid (DEV-1) described below, a fixing treatment at 25°C for 120 seconds was performed by using a fixing liquid (FIX-1) described below.

**(Development liquid (DEV-1))**

| | |
|---|---|
| Pure water | 500 cm³ |
| Metol | 2 g |
| Anhydrous sodium sulfite | 80 g |
| Hydroquinone | 4 g |
| Borax | 4 g |
| Sodium thiosulfate | 10 g |
| Potassium bromide | 0.5 g |
| The total amount was set to 1,000 cm³ by adding water. | |

**(Fixing liquid (FIX-1))**

| | |
|---|---|
| Pure water | 750 cm³ |
| Sodium thiosulfate | 250 g |
| Anhydrous sodium sulfite | 15 g |
| Glacial acetic acid | 15 cm³ |
| Potassium alum | 15 g |
| The total amount was set to 1,000 cm³ by adding water. | |

### (Physical development)

After physical development was performed at 30°C for 10 minutes on the photosensitive material after the fixing treatment by using a physical development liquid (PDEV-1) as below, a water washing treatment was performed with tap water for 10 minutes.

**(Physical development liquid (PDEV-1))**

| | |
|---|---|
| Pure water | 900 cm³ |
| Citric acid | 10 g |
| Trisodium citrate | 1 g |
| Ammonia water (28%) | 1.5 g |
| Hydroquinone | 2.3 g |
| Silver nitrate | 0.23 g |
| The total amount was set to 1,000 cm³ by adding water. | |

### (Electrolytic plating)

After the physical development treatment, a electrolytic copper plating treatment was performed at 25°C by using the electrolytic plating liquid, and water washing and dry treatments were performed. Current control in the electrolytic copper plating was performed at 3A for 1 minute and subsequently at 1A for 12 minutes, for 13 minutes in total. After the electrolytic copper plating treatment was completed, a water washing treatment was performed with tap water for 10 minutes, and drying was performed by using dry wind (50°C) so as to be a dry state.

**(Electrolytic plating liquid)**

| | |
|---|---|
| Copper sulfate (pentahydrate) | 200 g |
| Sulfuric acid | 50 g |
| Sodium chloride | 0.1 g |
| The total amount was set to 1,000 cm³ by adding water. | |

The surface of the support 11 was observed with an electron microscope, so as to check that the auxiliary metal wiring 13 having a line width of 19 µm and a pitch of 300 µm and consisting of a silver mesh pattern was formed on the PEN film (the support 11).

### (Forming of transparent negative electrode 12)

Inkjet printing was performed on the surface of the PEN film on which the auxiliary metal wiring 13 was formed by using a PEDOT-PSS aqueous solution (Clevios PH 500 (Product Name) manufactured by Heraeus Deutschland GmbH & Co. KG) (hereinafter, referred to as "PEDOT-PSS aqueous solution III") to which dimethyl sulfoxide (DMSO, 5 mass%), 3-glycidoxypropyltrimethoxysilane (2 mass%), and a fluorine-based surfactant (Zonyl FS-300 (Product Name) manufactured by Du Pont Kabushiki Kaisha, 0.5 mass%) were added. A heating treatment was performed at 120°C for 15 minutes, so as to form the PEDOT-PSS layer (film thickness: 0.2 µm) including polysiloxane as the transparent negative electrode 12.

### (Forming of electron transport layer 14)

After the transparent negative electrode 12 was rotary-coated with a titanium oxide fine particle dispersion liquid (Ti-Nanoxide HT-L/SC (Product Name) manufactured by Solaronix SA) to which a polyvinylbutyral aqueous solution (PVB, S-LEC K KW-1 (Product Name) manufactured by Sekisui Chemical Co., Ltd., 2 mass%) and 3-glycidoxypropyltrimethoxysilane (0.4 mass%) were added, a heating treatment was performed at 140°C for one hour, such that a titanium oxide layer (film thickness: 0.2 µm), including crosslinking PVB crosslinked by 3-glycidoxypropyltrimethoxysilane as a crosslinking agent was formed as the electron transport layer 14.

### (Forming of photoelectric conversion layer 15, hole transport layer 22, positive electrode 16, and protective layer 23)

The photoelectric conversion layer 15 was formed on the electron transport layer 14 in the same manner as the manufacturing of the solar cell No. 101.

Subsequently, after the photoelectric conversion layer 15 was rotary-coated with a PEDOT-PSS aqueous solution II, a heating treatment was performed at 120°C for 15 minutes, so as to form the hole transport layer 22 (film thickness: 0.1 µm) including polysiloxane.

The positive electrode 16 and the protective layer 23 were formed on the hole transport layer 22, in the same manner as the manufacturing of the solar cell No. 101.

### (Bonding of sealing film 25)

Two PEN films on which aluminum oxide vapor deposition films were formed as sealing films were respectively laminated on the back surface side of the support 11 and the protective layer 23 by vacuum heating (140°C) with ethylene-vinyl acetate copolymer (EVA) films interposed therebetween as sealants, such that the aluminum oxide vapor deposition films were on the inner side.

In this manner, the solar cell No. 201 was manufactured.

### (Manufacturing of solar cell No. 202)

The auxiliary metal wiring 13, the negative electrode 12, and electron transport layer 14 were formed on the support 11 in the same manner as the manufacturing of the solar cell No. 201.

Subsequently, the photoelectric conversion layer 15, the hole transport layer 22, the positive electrode 16, and the protective layer 23 were formed on the electron transport layer 14, in the same manner as the solar cell No. 102.

Two PEN films in which aluminum oxide vapor deposition films were formed as sealing films were respectively laminated on the back surface side of the support 11 and on the protective layer 23 by vacuum heating (120°C), with ionomer resins (HIGH MILAN 1652 (Product Name) manufactured by Du Pont-Mitsui Polychemicals) interposed therebetween as sealants, such that the aluminum oxide vapor deposition films were on the inner side.

In this manner, a solar cell No. 202 was manufactured.

### (Manufacturing of solar cell No. c201 for comparison)

In the manufacturing of the solar cell No. 201, the auxiliary metal wiring 13, the negative electrode 12, and the electron transport layer 14 were formed on the support 11 in the same manner as the manufacturing of the solar cell No. 201, except for performing rotary-coating on a titanium oxide fine particle dispersion liquid to which PVB and 3-glycidoxypropyltrimethoxysilane were not added, performing a heating treatment, so as to form the electron transport layer 14.

Subsequently, the photoelectric conversion layer 15, the hole transport layer 22, the positive electrode 16, and the protective layer 23 were formed on the electron transport layer 14, in the same manner as the manufacturing of the solar cell No. 101.

The sealing films 25 were laminated on the back surface side of the support 11 and the protective layer 23 in the same manner as the manufacturing of the solar cell No. 201, so as to manufacture a solar cell No. c201.

### (Manufacturing of solar cell No. c202 for comparison)

In the manufacturing of the solar cell No. 201, a solar cell No. c202 was manufactured in the same manner as the manufacturing of the solar cell No. 201, except for performing rotary-coating with a titanium oxide fine particle dispersion liquid to which PVB and 3-glycidoxypropyltrimethoxysilane were not added and forming an electron transport layer as a heating treatment.

### (Manufacturing of solar cell No. c203 for comparison)

In the manufacturing of the solar cell No. 201, a solar cell No. c203 was manufactured in the same manner as the manufacturing of the solar cell No. 201, except for performing rotary-coating with a titanium oxide fine particle dispersion liquid to which only a PVB aqueous solution was added without adding 3-glycidoxypropyltrimethoxysilane, performing a heating treatment, and forming an electron transport layer with a titanium oxide layer including non-crosslinking PVB.

### (Evaluation of solar cell)

The manufactured respective solar cells were folded, photoelectric conversion efficiency was measured before and after the folding, and durability was evaluated in the same manner as Example 1. The results were shown in Table 1 together with the results of the other examples.

The solar cell No. c201 was short-circuited immediately after the manufacturing, and thus the photoelectric conversion efficiency was not able to be measured.

### Example 3

In Example 3, the solar cell 1C illustrated in Fig. 3 was manufactured, and decrease ratios (durability) of photoelectric conversion efficiency before and after the folding were evaluated.

### (Manufacturing of solar cell No. 301)

In the order described below, a solar cell No. 301 according to the invention was manufactured.

The auxiliary metal wiring 13 was formed on the support 11 in the same manner as in the manufacturing of the solar cell No. 201.

### (Forming of transparent negative electrode 12 and electron transport layer 14)

Inkjet printing was performed with the PEDOT-PSS aqueous solution III on the surface of the PEN film on which the auxiliary metal wiring 13 was formed. Immediately, after the coating film of the PEDOT-PSS aqueous solution III was rotary-coated with an ethanol solution of Zn(acac)₂ (4 mass%), a heating treatment was performed at 140°C for one hour, so as to form the PEDOT-PSS layer (film thickness: 0.2 µm) including polysiloxane as the transparent negative electrode 12 and a zinc oxide layer (film thickness: 0.1 µm) including polysiloxane as the electron transport layer 14 at the same time.

It is considered that the polysiloxane of the zinc oxide layer was formed by 3-glycidoxypropyltrimethoxysilane of the PEDOT-PSS aqueous solution III shifted to an ethanol solution of Zn(acac)₂ (4 mass%) and condensed.

### (Forming of the porous layer 17)

The electron transport layer 14 was rotary-coated with a zinc oxide fine particle dispersion liquid (NanoSunguard in ethanol II (Product Name) manufactured by Buhler AG), so as to form the porous layer 17 (average film thickness: 0.3 µm) consisting of zinc oxide.

### (Forming of photoelectric conversion layer 15, hole transport layer 22, positive electrode 16, protective layer 23, and sealing film 25)

In the same manner as the manufacturing of the solar cell No. 201, the photoelectric conversion layer 15, the hole transport layer 22, the positive electrode 16, and the protective layer 23 were formed on the porous layer 17 and the sealing films 25 were laminated on the back surface side of the support 11 and the protective layer 23 by vacuum heating.

As described above, the solar cell No. 301 was manufactured.

### (Manufacturing of solar cell No. 302)

The auxiliary metal wiring 13, the negative electrode 12, and the electron transport layer 14 were formed on the support 11, in the same manner as the manufacturing of the solar cell No. 201.

### (Forming of porous layer 17 and photoelectric conversion layer 15)

The electron transport layer 14 was rotary-coated with an aluminum oxide fine particle dispersion liquid (642991 (Product Name) manufactured by Sigma-Aldrich Co., LLC.) so as to form the porous layer 17 (average film thickness: 0.3 µm) consisting of aluminum oxide.

Subsequently, the photoelectric conversion layer 15 was formed on the porous layer 17 in the same manner as the manufacturing of the solar cell No. 102.

### (Forming of hole transport layer 22, positive electrode 16, protective layer 23, and sealing film 25)

In the same manner as the manufacturing of the solar cell No. 202, the hole transport layer 22, the positive electrode 16, and the protective layer 23 were formed on the photoelectric conversion layer 15, and the sealing films 25 were laminated on the back surface side of the support 11 and on the protective layer 23 by vacuum heating.

As described above, the solar cell No. 302 was manufactured.

### (Manufacturing of solar cell No. c301 for comparison)

In the same manner as the manufacturing of the solar cell No. 201, the auxiliary metal wiring 13 and the negative electrode 12 were formed on the support 11.

### (Forming of electron transport layer, porous layer, and photoelectric conversion layer)

Subsequently, in the manufacturing of the solar cell No. 201, an electron transport layer was formed in the same manner as the manufacturing of the solar cell No. 201, except for performing rotary-coating with a titanium oxide fine particle dispersion liquid without adding PVB and 3-glycidoxypropyltrimethoxysilane and performing heating treatment, so as to form an electron transport layer.

In the same manner as the manufacturing of the solar cell No. 302, the porous layer 17 and the photoelectric conversion layer 15 were formed on this electron transport layer.

### (Forming of hole transport layer)

The photoelectric conversion layer 15 was rotary-coated with a chlorobenzene solution of spiro-OMeTAD (12 mass%) obtained by mixing an Li-TFSI (17 mass%) acetonitrile solution (5 mass%) and 4-tert-butylpyridine (1 mass%), so as to form a spiro-OMeTAD layer (film thickness: 0.05 µm).

Subsequently, after the spiro-OMeTAD layer was rotary-coated with the PEDOT-PSS aqueous solution I, a heating treatment was performed at 120°C for 15 minutes, so as to form the PEDOT-PSS layer (film thickness: 0.1 µm). This hole transport layer 22 consisted of a laminate structure of the spiro-OMeTAD layer and the PEDOT-PSS layer described above.

### (Forming of positive electrode, protective layer, and sealing film)

In the same manner as the manufacturing of the solar cell No. 302, the positive electrode 16 and the protective layer 23 was formed on the hole transport layer 22, the sealing films 25 were laminated on the back surface side of the support 11 and on the protective layer 23, so as to manufacture a solar cell No. c301.

### (Manufacturing of solar cell No. c302 for comparison)

In the manufacturing of the solar cell No. 302, a solar cell No. c302 was manufactured in the same manner as the manufacturing of the solar cell No. 302 except for performing rotary-coating a titanium oxide fine particle dispersion liquid without adding PVB and 3-glycidoxypropyltrimethoxysilane, performing a heating treatment, and forming the electron transport layer 14.

### (Manufacturing of solar cell No. c303 for comparison)

In the manufacturing of the solar cell No. 302, a solar cell No. c303 was manufactured in the same manner as in the manufacturing of the solar cell No. 302, except for performing rotary-coating with a titanium oxide fine particle dispersion liquid to which only a PVB aqueous solution was added without adding 3-glycidoxypropyltrimethoxysilane, performing a heating treatment, and forming an electron transport layer on a titanium oxide layer including non-crosslinking PVB.

### (Evaluation of solar cell)

The manufactured respective solar cells were folded, and the photoelectric conversion efficiency was measured before and after the folding, and durability was evaluated in the same manner as Example 1. The results are shown in Table 1 together with the results of the other examples.

The solar cell No. c301 was short-circuited immediately after the manufacturing, and thus the photoelectric conversion efficiency was not able to be measured.

**[Table 1]**

| | Solar cell No. | Durability test |
|---|---|---|
| | 101 | S |
| | 102 | A |
| Example 1 | c101 | B |
| (Fig. 1) | c102 | B |
| | c103 | C |
| | c104 | C |
| | 201 | A |
| Example 2 | 202 | A |
| (Fig. 2) | c201 | Unable to be evaluated |
| | c202 | C |
| | c203 | C |
| | 301 | A |
| Example 3 | 302 | A |
| (Fig. 3) | c301 | Unable to be evaluated |
| | c302 | C |
| | c303 | C |

As shown in Table 1, the solar cell according to the invention comprising the electron transport layer containing the insulating material and the crosslinking macromolecule had excellent durability with respect to folding in any structures illustrated in Figs. 1 to 3.

It has been found that, in the solar cell comprising the auxiliary metal wiring and the negative electrode, if a polyfunctional compound that reacted with the metal material included in the auxiliary metal wiring was used, durability was excellent (the solar cells Nos. 101 and 102). It has been found that, in the solar cell comprising the conductive macromolecule and the negative electrode formed with the specific polymer, if the polyfunctional compound that reacted or was polymerized with the polymer was used, the durability was excellent (the solar cells Nos. 201, 202, 301, and 302).

In contrast, the solar cell in which the electron transport layer that did not contain the crosslinking macromolecule, in any structures illustrated in Figs. 1 to 3, durability with respect to folding was insufficient.

Particularly, even if the electron transport layer includes the crosslinkable macromolecule, if the crosslinkable macromolecule is not crosslinked with the crosslinking agent, a solar cell having excellent durability with respect to folding was not able to be obtained (the solar cells Nos. c102, c104, c203, and c303).

### Explanation of References

- 1A, 1B, 1C: solar cell
- 11: support
- 12: negative electrode
- 13: auxiliary metal wiring
- 14: electron transport layer
- 15: photoelectric conversion layer
- 16: positive electrode
- 17: porous layer
- 21: gas barrier layer
- 22: hole transport layer
- 23: protective layer
- 24: adhesive layer
- 25: sealing film

## Claims

1. A solar cell comprising, on a support:
a transparent negative electrode;
auxiliary metal wiring that is in contact with the negative electrode;
a positive electrode that faces the negative electrode;
a photoelectric conversion layer between the negative electrode and the positive electrode; and
an electron transport layer between the negative electrode and the photoelectric conversion layer,
wherein the electron transport layer includes an electron transport material and an insulating material, and
wherein the insulating material is a crosslinking macromolecule obtained by crosslinking a crosslinkable macromolecule with a compound having a plurality of crosslinkable groups.

2. The solar cell according to claim 1,
wherein the crosslinkable group also functions as a reactive group that chemically bonds to a material for forming the negative electrode or the auxiliary metal wiring with which the electron transport layer is in contact.

3. The solar cell according to claim 1 or 2,
wherein the negative electrode contains a conductive macromolecule.

4. The solar cell according to any one of claims 1 to 3,
wherein the negative electrode contains a polymer of a compound having the plurality of crosslinkable groups.

5. The solar cell according to any one of claims 1 to 4,
wherein the electron transport material is metal oxide.

6. The solar cell according to any one of claims 1 to 5,
further comprising a porous layer between the electron transport layer and the photoelectric conversion layer.

7. The solar cell according to any one of claims 1 to 6,
wherein the photoelectric conversion layer contains an electron-donating organic compound.

8. The solar cell according to any one of claims 1 to 6,
wherein the photoelectric conversion layer contains a compound having a perovskite structure.

9. The solar cell according to any one of claims 1 to 8,
wherein the support is flexible.

10. The solar cell according to any one of claims 1 to 9, further comprising:
a second support bonded to a side opposite to the support.
